# EUROPEAN PATENT SPECIFICATION

(11) **EP 2 695 212 B1**
(45) Date of publication and mention of the grant of the patent: **23.05.2018**
(21) Application number: 12716506.6
(22) Date of filing: 02.04.2012
(51) Int. Cl.: H01L 51/54, B82Y 10/00, C08G 61/12, C08K 3/04

(54) **ORGANIC LIGHT EMITTING DEVICE AND METHOD**
ORGANISCHES LICHTEMITTIERENDES BAUELEMENT UND VERFAHREN
DISPOSITIF D'ÉMISSION DE LUMIÈRE ORGANIQUE ET PROCÉDÉ ASSOCIÉ

(30) Priority: 01.04.2011 GB 201105582
(43) Date of publication of application: 12.02.2014
(73) Proprietor: Cambridge Display Technology Limited, Cardinal Way Godmanchester Cambridgeshire PE29 2XG (GB); Sumitomo Chemical Company Limited, Tokyo 104-8260 (JP)
(72) Inventor: KUGLER, Thomas, J., Cambridgeshire CB23 6DW (GB); WILSON, Richard, J., Cambridgeshire CB23 6DW (GB); TYLER, Sarah, M., Cambridgeshire CB23 6DW (GB); YAMAUCHI, Shohgo, Ibaraki 300-3294 (JP); SHAKUTSUI, Masato, Ibaraki 300-3294 (JP); GODA, Tadashi, Ibaraki 300-3294 (JP); ITO, Norihito, Ibaraki 300-3294 (JP)
(74) Representative: Sharp, Alan Cooper
(86) International application number: PCT/GB2012/000304
(87) International publication number: WO 2012/131314

(56) References cited:
- EP-A1- 1 950 818
- WO-A1-2006/045199
- WO-A1-2010/029542
- US-A1- 2006 226 770
- US-A1- 2007 170 421

## Description

### Field of the Invention

This invention relates to organic light-emitting devices comprising a doped organic semiconductor and methods of making the same.

### Background of the Invention

Electronic devices comprising active organic materials are attracting increasing attention for use in devices such as organic light emitting diodes, organic photoresponsive devices (in particular organic photovoltaic devices and organic photosensors), organic transistors and memory array devices. Devices comprising organic materials offer benefits such as low weight, low power consumption and flexibility. Moreover, use of soluble organic materials allows use of solution processing in device manufacture, for example inkjet printing or spin-coating.

An organic optoelectronic device may comprise a substrate carrying an anode, a cathode and an organic semiconducting layer between the anode and cathode.

The organic semiconducting layer is an organic light-emitting layer in the case where the device is an organic light-emitting device (OLED). Holes are injected into the device through the anode (for example indium tin oxide, or ITO) and electrons are injected through the cathode during operation of the device. Holes in the highest occupied molecular orbital (HOMO) and electrons in the lowest unoccupied molecular orbital (LUMO) of the light combine to form an exciton that releases its energy as light. Suitable light-emitting materials include small molecule, polymeric and dendrimeric materials. Suitable light-emitting polymers for use in layer include poly(arylene vinylenes) such as poly(p-phenylene vinylenes) and polyarylenes such as polyfluorenes. Alternatively or additionally, the light-emitting layer may comprise a host material and a light-emitting dopant, for example a fluorescent or phosphorescent dopant.

The operation of an organic photovoltaic device or photosensor entails the reverse of the above-described process in that photons incident on the organic semiconducting layer generate excitons that are separated into holes and electrons.

In order to facilitate the transfer of holes and electrons into the light-emitting layer of an OLED (or transfer of separated charges towards the electrodes in the case of a photovoltaic or photosensor device) additional layers may be provided between the anode and the cathode.

A doped hole injection layer, which may be formed from a conductive organic or inorganic material, may be provided between the anode and the semiconducting layer or layers.

An example of a doped organic hole injection material is doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®. PEDT is deposited from an aqueous formulation.

Examples of conductive inorganic materials used as hole injection layers include transition metal oxides such as VOx MoOx and RuOx as disclosed in Journal of Physics D: Applied Physics (1996), 29(11), 2750-2753.

Hole injection layers formed by p-doping a conjugated material with metal compounds such as FeCl₃ or SbF₅ are disclosed in Chen et al, J. Appl. Phys. 96(1), 454-458, 2004 and in G. Crecelius, M. Stamm, J. Fink and J.J.Ritsko, Phys. Rev. Lett. 50, 1498-1500 (1983).

A hole injection layer formed by doping a conjugated polymer with tetrafluoro-tetracyanoquinodimethane (F4TCNQ) is disclosed in WO2008/029155.

WO 2010/029542 discloses fluorinated fullerene dopants.

JP 2007-254246 discloses certain solvents for fluorinated fullerene.

EP 1950818 discloses an OLED comprising a layer of fluorinated fullerene.

US2006/0226770 discloses an OLED with a hole injection layer comprising a semiconductor material doped with fullerene.

### Summary of the Invention

In a first aspect the invention provides an organic light-emitting device comprising an anode formed from a metal, a metal alloy, a conductive metal oxide or mixtures thereof; a hole injection layer in physical contact with the anode; a light-emitting layer over the hole injection layer; and a cathode over the light-emitting layer, wherein the hole injection layer comprises an organic semiconductor material doped with a partially fluorinated fullerene.

Optionally, the anode is selected from the group consisting of indium tin oxide, indium zinc oxide, fluorine-doped tin oxide, tungsten trioxide, titanium dioxide, molybdenum trioxide, aluminium zinc oxide, gallium indium zinc oxide, aluminium, silver, palladium, copper, gold, platinum, and alloys thereof, for example silver-palladium-copper and molybdenum-chrome, preferably indium tin oxide, silver-palladium-copper and silver. Optionally, the partially fluorinated fullerene is a partially fluorinated Buckminster fullerene. Optionally, the dopant is present in the range of about 0.1-20 wt %, optionally 0.1-5 wt %.

Optionally, the organic semiconductor is a polymer.

Optionally, the organic semiconductor comprises repeat units of formula (1): 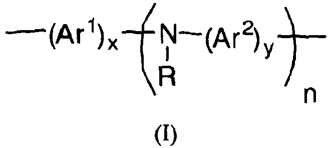 wherein Ar¹ and Ar² in each occurrence are independently selected from optionally substituted aryl or heteroaryl groups; n is greater than or equal to 1, preferably 1 or 2; R is H or a substituent, preferably a substituent; any of Ar¹, Ar² and R may be linked by a direct bond or linking group; and x and y are each independently 1, 2 or 3.

Optionally, the organic semiconductor is a copolymer comprises less than 50 mol% of repeat units of formula (I).

Optionally, the polymer comprises an optionally substituted arylene repeat unit, preferably an optionally substituted fluorene repeat unit or an optionally substituted phenylene repeat unit.

Optionally, a substantially undoped hole transporting layer, optionally a crosslinked layer, is disposed between the doped hole injection layer and the light-emitting layer.

Optionally, the hole-injection layer is crosslinked.

Optionally, the device comprises a patterned light-emitting layer defining a plurality of pixel of the device, each pixel having a pixel area, and a bank having openings at positions corresponding to the plurality of pixels.

Optionally, the hole-injection layer and light-emitting layer are disposed at least in the openings and in the pixel areas of the device.

Optionally, the hole injection layer is also disposed on the bank.

Optionally, the hole injection layer extends across a plurality of pixels of the device.

Optionally, the plurality of pixels form a row of pixels and wherein the device comprises a plurality of rows of pixels.

Optionally, the hole injection layer is disposed in the form of being divided for every pixel.

Optionally, the device comprises a bank defining a plurality of wells, each well defining a perimeter of a pixel.

Optionally, the device comprises a bank defining a plurality of channels, each channel extending across a plurality of pixels.

Optionally, the number of layers of the bank is one.

Optionally, the plurality of pixels are linearly arranged in a plurality of parallel rows; the the bank is composed of a first bank layer and a second bank layer on the first bank layer; the first bank layer defines a perimeter of the plurality of pixels, and the second bank layer divides the plurality of pixels into the plurality of parallel rows.

In a second aspect the invention provides a method of forming an organic light-emitting device as described in the first aspect, the method comprising the steps of:
providing a substrate carrying the anode;
depositing the doped organic semiconductor onto the anode to form the hole injection layer;
depositing a light-emitting material or light-emitting composition to form a light-emitting layer over the hole injection layer; and
forming a cathode over the light-emitting layer.

Optionally according to the second aspect, the hole transporting layer described in the first aspect is formed by depositing a substantially undoped hole transporting material or hole transporting composition over the hole injection layer.

Optionally according to the second aspect, the hole injection layer is formed by depositing a composition comprising the doped organic semiconductor and a solvent and evaporating the solvent.

Optionally according to the second aspect, the light-emitting layer is formed by depositing a composition comprising the hole transporting material and a solvent and evaporating the solvent.

Optionally according to the second aspect, the hole transporting layer is formed by depositing a composition comprising a substantially undoped hole transporting material and a solvent and evaporating the solvent.

Optionally according to the second aspect, the hole injection layer and the light-emitting layer are formed by inkjet printing.

Optionally according to the second aspect, the hole injection layer and the light-emitting layer are deposited into a well formed from a single bank material.

Optionally according to the second aspect, the hole injection layer is crosslinked prior to deposition of the light-emitting layer or, if present, the hole-transporting layer.

Optionally according to the second aspect, the hole transporting layer is crosslinked prior to deposition of the light-emitting layer.

Optionally according to the second aspect, the method comprises the step of forming a hole injection layer in which the hole injection layer is disposed at least onto an area within the opening on the anode on a substrate on which a plurality of the anodes and the bank are formed; the step of forming a light-emitting layer in which the light-emitting layer is disposed at least onto an area within the opening above the hole injection layer; and the step of forming a cathode in which the cathode is disposed on the light-emitting layer, wherein in the step of forming the hole injection layer, the hole injection layer being formed by applying an ink formed from the doped organic semiconductor and a solvent at least onto an area within the opening, and evaporating the solvent. Optionally according to the second aspect, in the step of forming the hole injection layer, the hole injection layer is formed by applying the ink onto an anode within the opening and the bank and evaporating the solvent.

Optionally according to the second aspect, in the step of forming the hole injection layer, the hole injection layer is formed by applying the ink onto an anode within the opening and a whole area of the bank and evaporating the solvent.

Optionally according to the second aspect, the plurality of openings are linearly arranged to form a row and a plurality of the rows are arranged parallel to one another, in the step of forming the hole injection layer, the hole injection layer is formed by applying the ink linearly along the row and evaporating the solvent.

Optionally according to the second aspect, in the step of forming the hole injection layer, the hole injection layer is formed by applying the ink for every opening and drying the ink. A third aspect, not forming part of the invention, provides a composition comprising at least one solvent and an organic semiconductor doped with a partially fluorinated fullerene wherein the at least one solvent is a mono- or poly-alkylated benzene.

The organic semiconductor and the partially fluorinated fullerene of the third aspect may be as described in the first aspect of the invention. A fourth aspect, not forming part of the invention, provides a composition comprising an organic semiconductor doped with a partially fluorinated fullerene wherein the organic semiconductor is a copolymer comprising one or more first repeat units and one or more further repeat units wherein the one or more first repeat units are independently selected from repeat units of formula (1): 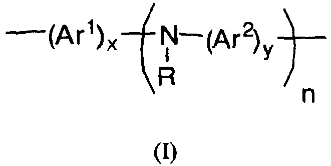 wherein Ar¹ and Ar² in each occurrence are independently selected from optionally substituted aryl or heteroaryl groups; n is greater than or equal to 1, preferably 1 or 2; R is H or a substituent, preferably a substituent; any of Ar¹, Ar² and R may be linked by a direct bond or linking group; and x and y are each independently 1, 2 or 3; and wherein the one or more first repeat units are present in an total amount of less than 50 mol% relative to the one or more further co-repeat units.

The organic semiconductor copolymer and the partially fluorinated fullerene of the fourth aspect may be as described in any part of the first aspect of the invention.

For the avoidance of any doubt, the doped organic semiconductor referred to herein has a different conductivity to the organic semiconductor prior to doping, and may be an extrinsic or degenerate organic semiconductor.

### Description of the Figures

The invention will now be described in more detail with reference to the drawings, in which:
Figure 1 illustrates an OLED according to a first embodiment of the invention;
Figure 2 illustrates an OLED according to a second embodiment of the invention;
Figure 3 illustrates a process for forming a doped formulation according to an embodiment of the invention;
Figure 4 illustrates an inkjet well containing an inkjet printed hole-injection layer and light emitting layer according to an embodiment of the invention;
Figure 5A illustrates UV-Visible absorption spectra for formulations having a range of doping levels according to embodiments of the invention;
Figure 5B illustrates UV-Visible absorption spectra for formulations according to further embodiments of the invention;
Figure 6 illustrates UV-Visible absorption spectra for C₆₀F₃₆ in ortho-xylene and in 1,2-dichlorobenzene;
Figure 7 illustrates electroluminescent spectra for devices according to embodiments of the invention and a comparative device;
Figure 8 illustrates external quantum efficiency vs. voltage for devices according to embodiments of the invention and a comparative device;
Figure 9 illustrates half-life for devices according to embodiments of the invention and a comparative device;
Figure 10 is a sectional view of a light-emitting apparatus according to an embodiment of the invention;
Figure 11-1 is a plan view of a single bank structure of a device according to an embodiment of the invention;
Figure 11-2 is a sectional view of a single bank structure of a device according to an embodiment of the invention;
Figure 12-1 is a plan view of a dual bank structure of a device according to an embodiment of the invention;
Figure 12-2 is a sectional view of a dual bank structure of a device according to an embodiment of the invention;
Figure 13-1 is a plan view of a dual bank structure of a device according to an embodiment of the invention in which a second bank has a channel structure;
Figure 13-2 is a sectional view of a dual bank structure of a device according to an embodiment of the invention in which a second bank has a channel structure;
Figure 14 is a plan view representing the situation in which in the light-emitting apparatus of a device according to an embodiment of the invention has a single bank structure, a hole injection layer is disposed to extend across all of plural organic light-emitting devices in the form of organic light-emitting devices combined into one.
Figure 15 is a plan view representing the situation in which in the light-emitting apparatus which has a single bank structure, a plurality of organic light-emitting devices are linearly arranged to form a row and a plurality of the rows are arranged parallel to one another, the hole injection layer is disposed to extend across a plurality of organic light-emitting devices composing the row in the form of hole injection layers combined linearly in each row of the plurality of the rows.
Figure 16 is a plan view representing the situation in which in the light-emitting apparatus having a single bank structure, the hole injection layer is disposed in the form of being divided for every organic light-emitting device.

### Detailed Description of the Invention

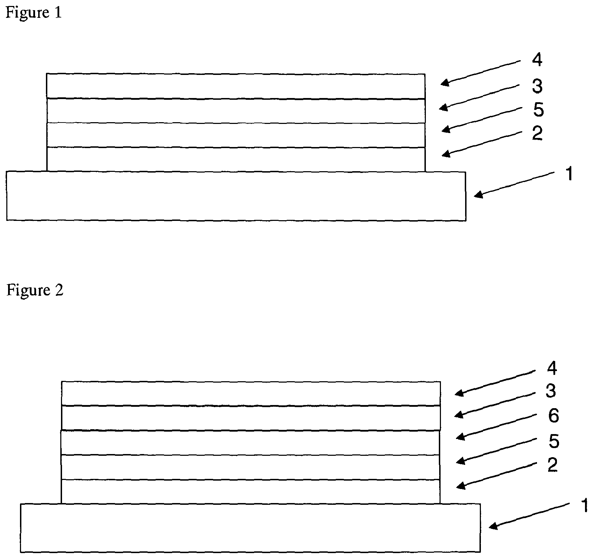

Figure 1 illustrates an OLED according to a first embodiment of the invention comprising a substrate 1, an anode 2, a light-emitting layer 3 and a cathode 4.

A hole injection layer 5 comprising an organic semiconductor doped with a partially fluorinated fullerene is provided between anode 2 and light-emitting layer 3.

Figure 2 illustrates an OLED according to a second embodiment of the invention comprising the elements of Figure 1 and a hole-transporting layer 6 between the hole injection layer 5 and the light-emitting layer 3.

Additional layers may be provided between the anode 2 and cathode 4 of Figures 1 and 2, for example one or more of electron transporting layers, hole transporting layers (which would be further hole transporting layers in the case of Figure 2), electron blocking layers and / or hole blocking layers.

The hole injection layer may have a thickness in the range of 10-200 nm, optionally 10-100 nm.

### Fullerenes

Fullerenes may be any carbon allotrope in the form of a hollow sphere or ellipsoid.

The fullerene may consist of carbon atoms arranged in 5, 6 and / or 7 membered rings, preferably 5 and / or 6 membered rings. C₆₀ Buckminster Fullerene is particularly preferred.

The partially fluorinated fullerene may have formula CₐF_{b} wherein b is in the range of 10 - 60 and a is more than b. Examples include C₆₀F₁₈, C₆₀F₂₀, C₆₀F₃₆, C₆₀F₄₈, C₇₀F₄₄, C₇₀F₄₆, C₇₀F₄₈, and C₇₀F₅₄. Partially fluorinated fullerenes and their synthesis are described in more detail in, for example, Andreas Hirsch and Michael Brettreich, "Fullerenes: Chemistry and Reactions", 2005 Wiley-VCH Verlag GmbH & Co KGaA, and in "The Chemistry Of Fullerenes", Roger Taylor (editor) Advanced Series in Fullerenes - Vol. 4 .

The partially fluorinated fullerene may consist of carbon and fluorine only or may include other elements, for example halogens other than fluorine and / or oxygen.

The partially fluorinated fullerene may have a LUMO level in the range of about -4.0 to - 5.0 eV as measured by cyclic voltammetry relative to a Saturated Calomel Electrode (SCE) in acetonitrile using tetraethylammonium perchlorate as supporting electrolyte, and assuming the LUMO level of SCE as 4.94 eV.

### Organic semiconductor material

The hole-transporting material may be any form of material, including small molecule and polymeric materials, having a HOMO level capable of undergoing p-doping with the partially fluorinated fullerene dopant. Doping of an organic semiconductor is apparent from doping-induced features in the UV-visible absorption spectrum of a solution of the organic semiconductor and dopant.

The HOMO level of the organic semiconductor material as measured by photoelectron spectroscopy may be any value up to -5.8 eV from vacuum level.

Where the hole transporting material is a polymer, it may comprise amine-containing repeat units, for example amine repeat units of formula (I): 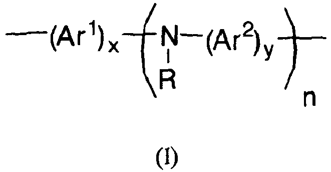 wherein Ar¹ and Ar² in each occurrence are independently selected from optionally substituted aryl or heteroaryl groups, n is greater than or equal to 1, preferably 1 or 2, R is H or a substituent, preferably a substituent, and x and y are each independently 1, 2 or 3.

R is preferably alkyl, for example C₁₋₂₀ alkyl, Ar³, or a branched or linear chain of Ar³ groups, for example -(Ar³)ᵣ, wherein Ar³ in each occurrence is independently selected from aryl or heteroaryl and r is at least 1, optionally 1, 2 or 3.

Any of Ar¹, Ar² and Ar³ may independently be substituted with one or more substituents. Preferred substituents are selected from the group R³ consisting of:
alkyl, for example C₁₋₂₀ alkyl, wherein one or more non-adjacent C atoms may be replaced with O, S, substituted N, C=O and -COO- and one or more H atoms of the alkyl group may be replaced with F or aryl or heteroaryl optionally substituted with one or more groups R⁴,
aryl or heteroaryl optionally substituted with one or more groups R⁴,
NR⁵₂, OR⁵, SR⁵,
fluorine, nitro and cyano, and
crosslinkable groups;
wherein each R⁴ is independently alkyl, for example C₁₋₂₀ alkyl, in which one or more non-adjacent C atoms may be replaced with O, S, substituted N, C=O and -COO- and one or more H atoms of the alkyl group may be replaced with F, and each R⁵ is independently selected from the group consisting of alkyl and aryl or heteroaryl optionally substituted with one or more alkyl groups.

R may comprise a crosslinkable-group, for example a group comprising a polymerisable double bond such and a vinyl or acrylate group, or a benzocyclobutane group.

Any of the aryl or heteroaryl groups in the repeat unit of Formula (I) may be linked by a direct bond or a divalent linking atom or group. Preferred divalent linking atoms and groups include O, S; substituted N; and substituted C.

Where present, substituted N or substituted C of R³, R⁴ or of the divalent linking group may independently in each occurrence be NR⁶ or CR⁶₂ respectively wherein R⁶ is alkyl or optionally substituted aryl or heteroaryl. Optional substituents for aryl or heteroaryl groups R⁶ may be selected from R⁴ or R⁵.

In one preferred arrangement, R is Ar³ and each of Ar¹, Ar² and Ar³ are independently and optionally substituted with one or more C₁₋₂₀ alkyl groups.

Particularly preferred units satisfying Formula 1 include units of Formulae 1-3: 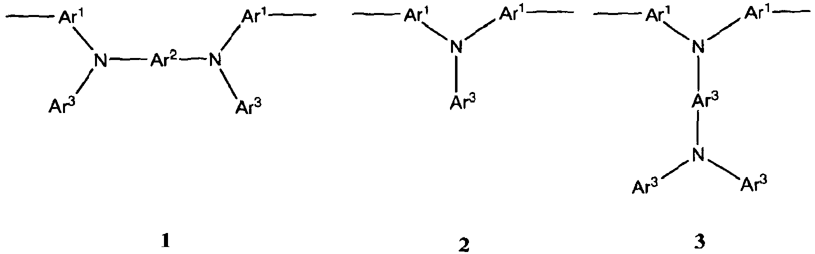 wherein Ar¹ and Ar² are as defined above; and Ar³ is optionally substituted aryl or heteroaryl. Where present, preferred substituents for Ar³ include substituents as described for Ar¹ and Ar², in particular alkyl and alkoxy groups.

Ar¹, Ar² and Ar³ are preferably phenyl, each of which may independently be substituted with one or more substituents as described above.

In another preferred arrangement, aryl or heteroaryl groups of formula (I) are phenyl, each phenyl group being optionally substituted with one or more alkyl groups.

In another preferred arrangement, Ar¹, Ar² and Ar³ are phenyl, each of which may be substituted with one or more C₁₋₂₀ alkyl groups, and r = 1.

In another preferred arrangement, Ar¹ and Ar² are phenyl, each of which may be substituted with one or more C₁₋₂₀ alkyl groups, and R is 3,5-diphenylbenzene wherein each phenyl may be substituted with one or more alkyl groups.

The hole-transporting polymer may be a homopolymer comprising repeat units of formula (I). Alternatively, the hole transporting polymer may be a copolymer, for example a random, alternating or block copolymer comprising one or more repeat units of formula (I) and further repeat units.

Further repeat units may be selected from:
- one or more further repeat units of formula (1) that are different to the first repeat unit; and
- one or more optionally substituted (hetero)arylene repeat units, for example optionally substituted fluorene, phenylene and / or indenofluorene repeat units.

The repeat units of formula (I) may make up less than 50 mol% of the repeat units of the copolymer.

Exemplary fluorene repeat units include repeat units of formula (II): 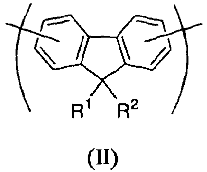 wherein R¹ and R² are independently H or a substituent and wherein R¹ and R² may be linked to form a ring.

R¹ and R² are optionally selected from the group consisting of hydrogen; optionally substituted Ar³ or a linear or branched chain of Ar³ groups, wherein Ar³ is as described above; and optionally substituted alkyl, for example C₁₋₂₀ alkyl, wherein one or more non-adjacent C atoms of the alkyl group may be replaced with O, S, substituted N, C=O and - COO-.

In the case where R¹ or R² comprises alkyl, optional substituents of the alkyl group include F, CN, nitro, and aryl or heteroaryl optionally substituted with one or more groups R⁴ wherein R⁴ is as described above.

In the case where R¹ or R² comprises aryl or heteroaryl, each aryl or heteroaryl group may independently be substituted. Preferred optional substituents for the aryl or heteroaryl groups include one or more substituents R³.

Optional substituents for the fluorene unit, other than substituents R¹ and R², are preferably selected from the group consisting of alkyl wherein one or more non-adjacent C atoms may be replaced with O, S, substituted N, C=O and -COO-, optionally substituted aryl, optionally substituted heteroaryl, fluorine, cyano and nitro.

Where present, substituted N in repeat units of formula (II) may independently in each occurrence be NR⁵ or NR⁶.

In one preferred arrangement, at least one of R¹ and R² comprises an optionally substituted C₁-C₂₀ alkyl or an optionally substituted aryl group, in particular phenyl substituted with one or more C₁₋₂₀ alkyl groups.

R¹ and / or R² may be crosslinkable. For example, R¹ and / or R² may comprise a polymerisable double bond such and a vinyl or acrylate group, or a benzocyclobutane group.

The repeat units of formula (II) may be 2,7-linked.

Exemplary phenylene repeat units include repeat units of formula (III): 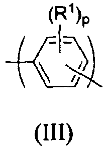 wherein R¹ is as described above with reference to formula (II) and p is 1, 2, 3 or 4, optionally 1 or 2. In one arrangement, the repeat unit is a 1,4-phenylene repeat unit.

The repeat unit of formula (III) may have formula (IIIa), wherein R¹ in each occurrence may be the same or different:

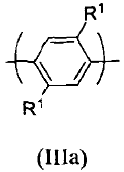

### Hole injection composition

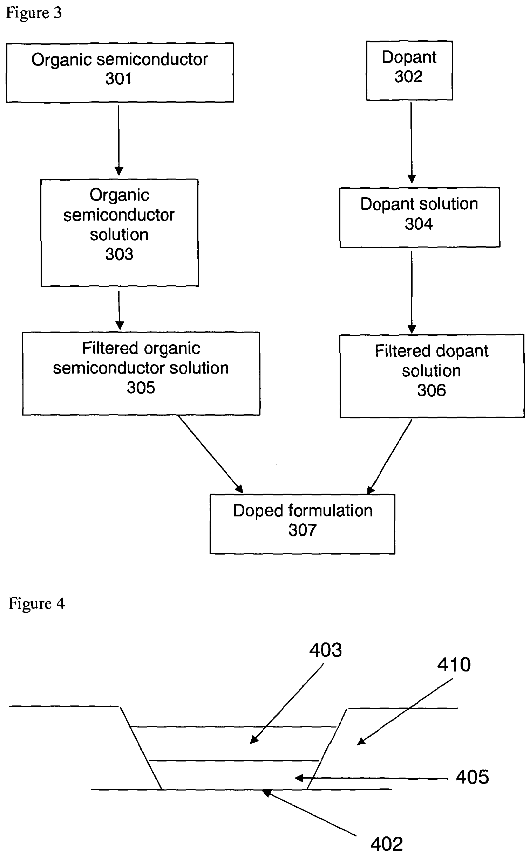

Figure 3 illustrates an exemplary process for forming a doped composition of an organic semiconductor doped with a partially fluorinated fullerene.

In steps 301 and 302 an organic semiconductor and a partially fluorinated fullerene material respectively are separately dissolved in a solvent to form solution 303 and solution 304 respectively. The solvents of the respective solutions are selected so as to be miscible, and may be the same or different.

The respective solutions may then be filtered (steps 305, 306) before being combined to form a solution of the doped organic semiconductor material (step 307).

A charge-transfer salt is formed following combination of the solutions, and the solvent or solvent mixture used may be selected so as to dissolve not only the starting materials but also the charge-transfer salt formed following combination of the solutions. Alternatively or additionally, the concentration of dopant may be selected to give a concentration of the charge transfer salt that is below the solubility limit for the charge transfer salt in the selected solvent or solvent mixture.

The partially fluorinated fullerene dopant may be provided in an amount from about 0.1 weight % or 0.5 weight % up to about 5 weight %, 10 weight %, 20 weight % or 30 weight % relative to the organic semiconductor, for example in the range of 3-15 wt %. The doping concentration may be selected so as to control resistivity of a film formed from the doped organic semiconductor. The resistivity of a film formed from the organic semiconductor may be greater than about 5x10⁵ Ohm cm.

Suitable solvents for organic semiconductors described above and partially fluorinated fullerenes include chlorinated solvents such as chlorinated benzenes, for example dichlorobenzene.

Organic semiconductor polymers comprising arylene repeat units, in particular alkylsubstituted arylene repeat units as described above, are soluble in mono- or poly-alkylated benzenes such as toluene, ortho-, meta- and para-xylene, mesitylene, tetraline, ethylbenzene and cyclohexylbenzene.

The number, size and / or position of substituents on an arylene solvent may be selected to control solubility of the organic semiconductor, dopant and / or charge transfer salt, and / or to control the boiling point, viscosity and / or contact angle of the solvent according to the deposition technique to be used in forming a film of the doped organic semiconductor.

The present inventors have surprisingly found that both partially fluorinated fullerenes and the charge-transfer salt formed following doping are soluble in mono- or poly-alkylated benzenes, for example as described above, up to doping levels required for formation of a hole injection layer, for example in a solution concentration of the doped material of about 0.5 - 1.5 weight %. This class of solvents are suitable for use in large-scale production and as such are particularly advantageous as compared to chlorinated solvents.

### Anodes

Suitable materials for forming the anode include metals, metal alloys, conductive metal oxides and mixtures thereof. The anode may be formed by a non-solution deposition process, for example evaporation or sputtering, and may be patternable by photolithography.

Exemplary metals include aluminium, silver, palladium, copper, gold, platinum, and alloys thereof, for example silver-palladium-copper and molybdenum-chrome.

Exemplary conductive metal oxides include indium tin oxide, indium zinc oxide, fluorine-doped tin oxide, tungsten trioxide, titanium dioxide, molybdenum trioxide, aluminium zinc oxide and gallium indium zinc oxide. Indium tin oxide is particularly preferred.

The present inventors have surprisingly found that the formation of electrical shorts in an OLED may be reduced if the surface of the anode forms an interface with a doped material, resulting in higher yield of functioning devices in a manufacturing process.

### Hole transporting layer

A hole transporting layer may be provided between the doped hole injection layer and the light-emitting layer.

The hole transporting layer may have a thickness in the range of 10-200 nm, optionally in the range of 10-100 nm.

The material used to form the hole transporting layer may be selected from any hole transporting material capable of providing little or no barrier to hole transport from the hole-injection layer to the light-emitting layer. Exemplary hole-transporting materials may be selected from any of the organic semiconductor materials described above, for example a polymer (homopolymer or copolymer) comprising a repeat unit of formula (I).

This layer may be formed from the same organic semiconductor used to form the doped hole injection layer in order to provide little or no barrier to charge transport from the hole injection layer to the light-emitting layer.

The organic semiconductor used to form the hole transporting layer is substantially undoped. Following deposition of the substantially undoped organic semiconductor onto the hole injection layer, there may be some diffusion of partially fluorinated fullerene from the hole injection layer resulting in some doping of the previously undoped organic semiconductor and a dopant gradient in an interface region between the hole injection layer and the hole transporting layer. This diffusion may occur in particular if the hole-transporting layer is heated following deposition, for example to crosslink or otherwise anneal the hole transporting layer. The material used to form the hole transporting layer may have a HOMO level of -5.8 eV or shallower as measured by photoelectron spectroscopy.

The hole transporting material may be provided with crosslinkable groups, for example crosslinkable groups as described above.

### Light emitting layer

Suitable light-emitting materials for use in the light-emitting layer include small molecule, polymeric and dendrimeric materials, and compositions thereof. Suitable light-emitting polymers include conjugated polymers, for example optionally substituted poly(arylene vinylenes) such as poly(p-phenylene vinylenes) and optionally substituted polyarylenes such as: polyfluorenes, particularly 2,7-linked 9,9 dialkyl polyfluorenes or 2,7-linked 9,9 diaryl polyfluorenes; polyspirofluorenes, particularly 2,7-linked poly-9,9-spirofluorene; polyindenofluorenes, particularly 2,7-linked polyindenofluorenes; polyphenylenes, particularly alkyl or alkoxy substituted poly-1,4-phenylene. Such polymers as disclosed in, for example, Adv. Mater. 2000 12(23) 1737-1750 and references therein.

Polymers for use as light-emitting materials in devices according to the present invention may comprise a repeat unit selected from optionally substituted amine repeat units of formula (I) and / or optionally substituted arylene or heteroarylene repeat units as described above, in particular fluorene repeat units of formula (II) described above.

The light-emitting layer may consist of a light-emitting material alone, or may comprise this material in combination with one or more further materials. In particular, the light-emitting material may be blended with hole and / or electron transporting materials or alternatively may be covalently bound to hole and / or electron transporting materials as disclosed in for example, WO 99/48160.

Light-emitting copolymers may comprise a light-emitting region and at least one of a hole transporting region and an electron transporting region as disclosed in, for example, WO 00/55927 and US 6353083. If only one of a hole transporting region and electron transporting region is provided then the electroluminescent region may also provide the other of hole transport and electron transport functionality - for example, an amine unit of formula (I) as described above may provide both hole transport and light-emission functionality. A light-emitting copolymer comprising light-emitting repeat units and one or both of a hole transporting repeat units and electron transporting repeat units may provide said units in a polymer main-chain, as per US 6353083, or in polymer side-groups pendant from the polymer backbone.

Suitable light-emitting materials may emit in the UV, visible and / or infra-red region of the electromagnetic spectrum. The OLED may contain one or more of red, green and blue light-emitting materials.

A blue light-emitting material may have photoluminescent spectrum with a peak wavelength in the range of less than or equal to 480 nm, such as in the range of 400-480 nm

A green light-emitting material may have photoluminescent spectrum with a peak wavelength in the range of above 480 nm - 560 nm.

A red light-emitting material may have photoluminescent spectrum with a peak wavelength in the range of above 560 nm - 630 nm.

More than one light-emitting material may be used. For example, red, green and blue light-emitting dopants may be used to obtain white light emission.

The light emitting layer may comprise a host material and at least one light-emitting dopant. The host material may be a material as described above that would, in the absence of a dopant, emit light itself. When a host material and dopant are used in a device, the dopant alone may emit light. Alternatively, the host material and one or more dopants may emit light. White light may be generated by emission from multiple light sources, such as emission from both the host and one or more dopants or emission from multiple dopants.

In the case of a fluorescent light-emitting dopant the singlet excited state energy level (S₁) of the host material should be higher than that of the fluorescent light-emitting dopant in order that singlet excitons may be transferred from the host material to the fluorescent light-emitting dopant. Likewise, in the case of a phosphorescent light-emitting dopant the triplet excited state energy level (T₁) of the host material should be higher than that of the phosphorescent light-emitting dopant in order that triplet excitons may be transferred from the host material to the fluorescent light-emitting dopant.

Exemplary phosphorescent light-emitting dopants include metal complexes comprising optionally substituted complexes of formula (IV):

ML¹_{q}L²ᵣL³ₛ (IV)

wherein M is a metal; each of L¹, L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on L³.

Heavy elements M induce strong spin-orbit coupling to allow rapid intersystem crossing and emission from triplet or higher states (phosphorescence). Suitable heavy metals M include d-block metals, in particular those in rows 2 and 3 i.e. elements 39 to 48 and 72 to 80, in particular ruthenium, rhodium, palladium, rhenium, osmium, iridium, platinum and gold. Iridium are particularly preferred.

Exemplary ligands L¹, L² and L³ include carbon or nitrogen donors such as porphyrin or bidentate ligands of formula (V): 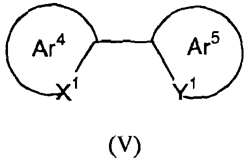 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be fused together. Ligands wherein X¹ is carbon and Y¹ is nitrogen are particularly preferred.

Examples of bidentate ligands are illustrated below:

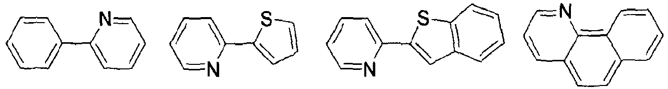

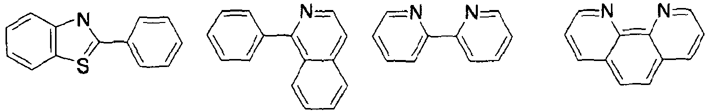

Each of Ar⁴ and Ar⁵ may carry one or more substituents. Two or more of these substituents may be linked to form a ring, for example an aromatic ring.

Other ligands suitable for use with d-block elements include diketonates, in particular acetylacetonate (acac); triarylphosphines and pyridine, each of which may be substituted.

Exemplary substituents include groups R³ groups R³ as described above with reference to Formula (I). Particularly preferred substituents include fluorine or trifluoromethyl which may be used to blue-shift the emission of the complex, for example as disclosed in WO 02/45466, WO 02/44189, US 2002-117662 and US 2002-182441; alkyl or alkoxy groups, for example C₁₋₂₀ alkyl or alkoxy, which may be as disclosed in JP 2002-324679; carbazole which may be used to assist hole transport to the complex when used as an emissive material, for example as disclosed in WO 02/81448; bromine, chlorine or iodine which can serve to functionalise the ligand for attachment of further groups, for example as disclosed in WO 02/68435 and EP 1245659; and dendrons which may be used to obtain or enhance solution processability of the metal complex, for example as disclosed in WO 02/66552.

A light-emitting dendrimer typically comprises a light-emitting core bound to one or more dendrons, wherein each dendron comprises a branching point and two or more dendritic branches. Preferably, the dendron is at least partially conjugated, and at least one of the branching points and dendritic branches comprises an aryl or heteroaryl group, for example a phenyl group. In one arrangement, the branching point group and the branching groups are all phenyl, and each phenyl may independently be substituted with one or more substituents, for example alkyl or alkoxy.

A dendron may have optionally substituted formula (VI) 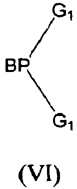 wherein BP represents a branching point for attachment to a core and G₁ represents first generation branching groups.

The dendron may be a first, second, third or higher generation dendron. G₁ may be substituted with two or more second generation branching groups G₂, and so on, as in optionally substituted formula (VIa): 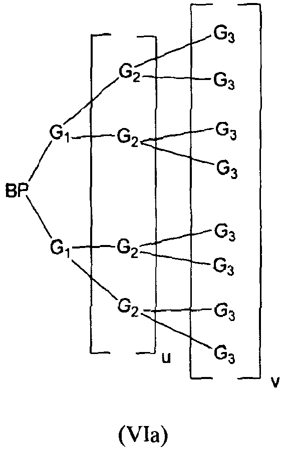 wherein u is 0 or 1; v is 0 if u is 0 or may be 0 or 1 if u is 1; BP represents a branching point for attachment to a core and G₁, G₂ and G₃ represent first, second and third generation dendron branching groups.

BP and / or any group G may be substituted with one or more substituents, for example one or more C₁₋₂₀ alkyl or alkoxy groups.

Where used, a light-emitting dopant may be present in an amount of about 0.05 mol % up to about 20 mol %, optionally about 0.1-10 mol % relative to their host material.

The light-emitting dopant may be physically mixed with the host material or it may be chemically bound to the host material in the same manner described above with respect to binding of the light-emitting dopant to the charge transporting material.

More than one light-emitting layer may be present.

The light-emitting layer may be patterned or unpatterned. A device comprising an unpatterned layer may be used an illumination source, for example. A white light emitting device is particularly suitable for this purpose. A device comprising a patterned layer may be, for example, an active matrix display or a passive matrix display. In the case of an active matrix display, a patterned electroluminescent layer is typically used in combination with a patterned anode layer and an unpatterned cathode. In the case of a passive matrix display, the anode layer is formed of parallel stripes of anode material, and parallel stripes of electroluminescent material and cathode material arranged perpendicular to the anode material wherein the stripes of electroluminescent material and cathode material are typically separated by stripes of insulating material ("cathode separators") formed by photolithography.

### Cathode

The cathode is selected from materials that have a workfunction allowing injection of electrons into the light-emitting layer. Other factors influence the selection of the cathode such as the possibility of adverse interactions between the cathode and the materials of the light-emitting layer. The cathode may consist of a single material such as a layer of aluminium. Alternatively, it may comprise a plurality of metals, for example a bilayer of a low workfunction material and a high workfunction material such as calcium and aluminium as disclosed in WO 98/10621; elemental barium as disclosed in WO 98/57381, Appl. Phys. Lett. 2002, 81(4), 634 and WO 02/84759; or a thin layer of metal compound, in particular an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode will comprise a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

In one arrangement, the surface of the cathode contacts a surface of the light-emitting layer. In another arrangement, one or more layers may be provided between the cathode and the light-emitting layer. For example, an organic electron-transporting layer may be provided between the light-emitting layer and the cathode.

### Encapsulation

OLEDs tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850. The substrate may be opaque in the case of an OLED with a transparent cathode.

The device is preferably encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric as disclosed in, for example, WO 01/81649 or an airtight container as disclosed in, for example, WO 01/19142. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Solution processing

The organic semiconductor doped with partially fluorinated fullerene may be deposited by any process, including vacuum co-evaporation of the organic semiconductor and partially fluorinated fullerene and deposition of a composition of the organic semiconductor and partially fluorinated fullerene from a solution in a solvent followed by evaporation of the solvent.

Solution deposition methods are preferred, particularly in the case where the hole-transporting material is a polymer. Solution deposition methods include coating techniques, such as spin-coating, dip-coating and blade coating and printing techniques such as inkjet printing, nozzle printing, screen printing and roll printing.

Inkjet printing is particularly suitable for high information content displays, in particular full colour displays. A device may be inkjet printed by providing a patterned layer over the first electrode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer, for example, by nozzle printing. In particular, the photoresist may be patterned to form channels which, unlike wells, extend over a plurality of pixels and which may be closed or open at the channel ends.

Each of the doped hole injection layer, the undoped hole transport layer (if present) and the light emitting layer may be formed by solution processing.

Figure 4 illustrates a doped hole injection layer 405 on anode surface 402 and a light-emitting layer 403 formed in an inkjet well by inkjet printing. The well perimeter is defined by a bank material 410, which may be a photoresist that has been patterned to define a well. A hole-transporting layer (not shown) may likewise by printed into the well. The bank defines a pixel area of the device. Each pixel may be further subdivided by the bank into two or more subpixels. The pixels of a full-colour device may be subdivided into at least three subpixels, including red, green and blue subpixels.

The doped composition used to form the hole injection layer may be soluble in organic solvents such as alkylated benzenes, as described above. Hole transport layers and light-emitting layers are typically formed by printing relevant materials in an organic solvent. In contrast, hole injection materials such as PEDOT:PSS are deposited from an aqueous formulation.

Printing of a hole injection material deposited from an aqueous formulation may involve use of a bank structure to form the wells wherein a first layer of the bank structure is formed from a material optimised for printing of an aqueous formulation and a second layer is formed from a material optimised for printing of an organic formulation. Printing of only organic formulations may allow this structure to be dispensed with.

When an ink, in which a hole injection material is dissolved, is applied in a well surrounded by a single bank composed of only one layer, it will be appreciated that an inclined plane of the bank (a side wall of the bank) may also become wet by the ink, and the resultant hole injection layer may rise along the inclined plane of the bank if the wet inclined plane is dried as-is. In this case, since the layer thickness of the light-emitting layer on the hole injection layer on the inclined plane of the bank is very small, or since an end of the hole injection layer existing on the inclined plane of the bank may not be covered fully by the light-emitting layer, a short circuit may form between the exposed hole injection material that has dried on the bank and the cathode.. (Rising of the hole injection layer along the inclined plane of the bank and the leak current are described in, for example, JP-A-2009-54582)

In order to suppress such a leak current, a dual bank structure composed of two layers different in the lyophilic/lyophobic properties of the bank for an ink is used (for example, Patent Publication No. JP3951445B2). When an ink of water-soluble hole injection material typified by PEDOT:PSS is applied in the well defined by this bank structure, and if the hydrophilicity of the first (lower) layer of the bank for a water-soluble ink is larger than the hydrophilicity of the second (upper) layer of the bank for the ink, in other words, if the second layer of the bank is hydrophobic, the applied water-soluble ink can form a layer without rising along the inclined plane of the second layer of the bank. Since the second layer of the bank has a hydrophobic property it may repel the water-soluble ink, but since it has a lyophilic property for the organic solvent-based ink, the light-emitting layer applied onto the hole injection layer, which is formed from the organic solvent-based ink, may dry to form a layer that rises along the inclined plane of the second layer of the bank, and an end of the PEDOT:PSS film can be covered with a thick layer. Thereby, short circuits between the hole injection layer and the cathode can be reduced or prevented.

Furthermore, it is possible to suppress leakage current in a single bank structure or a multiple bank structure by increasing the specific resistance of the hole injection layer.

The present inventors measured the specific resistance of hole injection layers by the four-terminal method. The measured specific resistance of a thin film of PEDOT:PSS (CLEVIOS™ P VP AI 4083 produced by Heraeus Holding), in which a weight ratio between PEDOT and PSS is 1 : 6, was 7.11x10² Ohm cm. On the other hand, the specific resistance of a thin film, which is formed from a solution obtained by doping SP1-with C₆₀F₃₆ of 3 wt% with respect to the SP1, was 1.93x10⁷ Ohm cm, and the specific resistance of that obtained by doping SP1 with C₆₀F₃₆ of 10 wt% was 1.18x10⁷ Ohm cm, and therefore these specific resistances were found to be five orders magnitude higher than that of 1:6 PEDOT:PSS. This magnitude of specific resistance is sufficiently high to reduce or eliminate short circuits since a thin film of PEDOT:PSS (CLEVIOS™ P VP CH 8000 produced by Heraeus Holding) aimed at suppressing cross talk of a display, in which a weight ratio between PEDOT and PSS is 1 : 20, has the specific resistance of 5.19x10⁵ Ohm cm (measurement by the four-terminal method).

When the thin film obtained by doping SP1 with C₆₀F₃₆ is used for the hole injection layer, it will be appreciated that leakage current can be suppressed even when the hole injection layer rises along the inclined plane of the bank. However, it is generally known that the specific resistance of the doped organic semiconductor varies significantly depending on the organic semiconductor and the amount of a dopant to be selected (e.g., described in Adv. Mater. 2008, 20, 3319-3324 or Chem. Rev. 2007, 107, 1233-1271).

Therefore, when the hole injection layer used in the organic light-emitting device of the present invention is applied, the dual bank structure is not necessarily required from the viewpoint of the specific resistance of the hole injection layer if the organic semiconductor and the dopant concentration are appropriately selected.

If multiple layers of an OLED are formed by solution processing, for example as illustrated in Figure 4 then techniques to prevent intermixing of adjacent layers include crosslinking of one layer before deposition of a subsequent layer and / or selection of materials for adjacent layers such that the material from which the first of these layers is formed is not soluble in the solvent used to deposit the second layer. Crosslinking may be thermal or photo-crosslinking.

The organic semiconductor used to form a doped hole injection layer or an undoped hole transporting layer may be substituted with a crosslinkable group. In the case of a hole-transporting polymer, a crosslinkable group may be provided as a substituent of one or more polymeric repeat units. Suitable crosslinkable groups include groups comprising a reactive carbon-carbon double bond such as vinyl and acrylate groups, in particular double bond groups including a CH₂ group, and groups comprising an optionally substituted benzocyclobutane.

Spin-coating is particularly suitable for devices wherein patterning of the electroluminescent material is unnecessary - for example for lighting applications or simple monochrome segmented displays.

### Examples

### Formulation Examples

Semiconducting Polymer 4, illustrated below, was dissolved in 1,2-dichlorobenzene (DCB) to give a 1 wt % solution. C₆₀F₃₆ was dissolved in 1,2-dichloroethane was dissolved in 1,2-dichloroboenzene to give a 1 wt % solution. Semiconducting polymer 4 (SP4) was formed by Suzuki polymerisation as described in WO 00/53656 of monomers in the relative molar amounts given below.

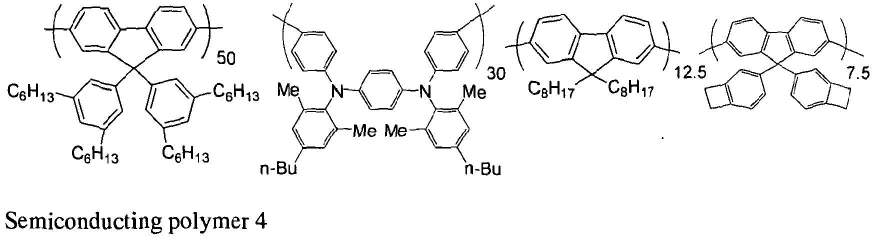

The two solutions were separately filtered through syringe filter discs having a pore size of 0.45 microns, and the filtered solutions were blended to give a doped formulation. The relative amounts of the two solutions were selected according to the desired doping level.

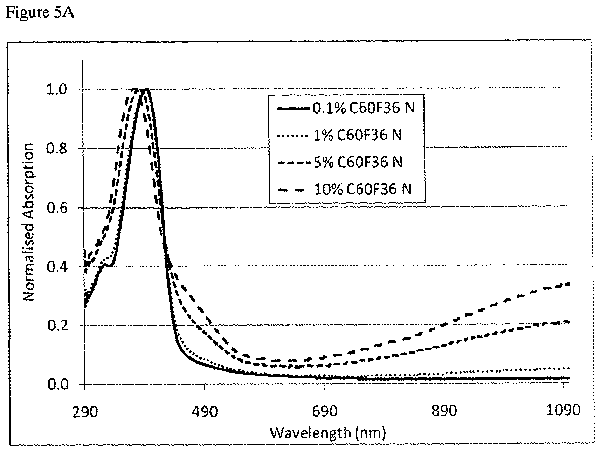

With reference to Figure 5a, the UV-visible absorption spectra of the formulation at 0.1, 1, 5 and 10 weight % doping shows doping-induced absorption features below about 500 nm and extending between about 700nm and 1100nm, indicating that Semiconducting Polymer 4 had been efficiently p-doped. The absorption features associated with doping increase with increasing doping concentration.

A distinct blue shift of the main absorption peak was observed at the highest dopant concentration.

Very similar spectra were obtained for solid films of C₆₀F₃₆-doped Semiconducting Polymer 4.

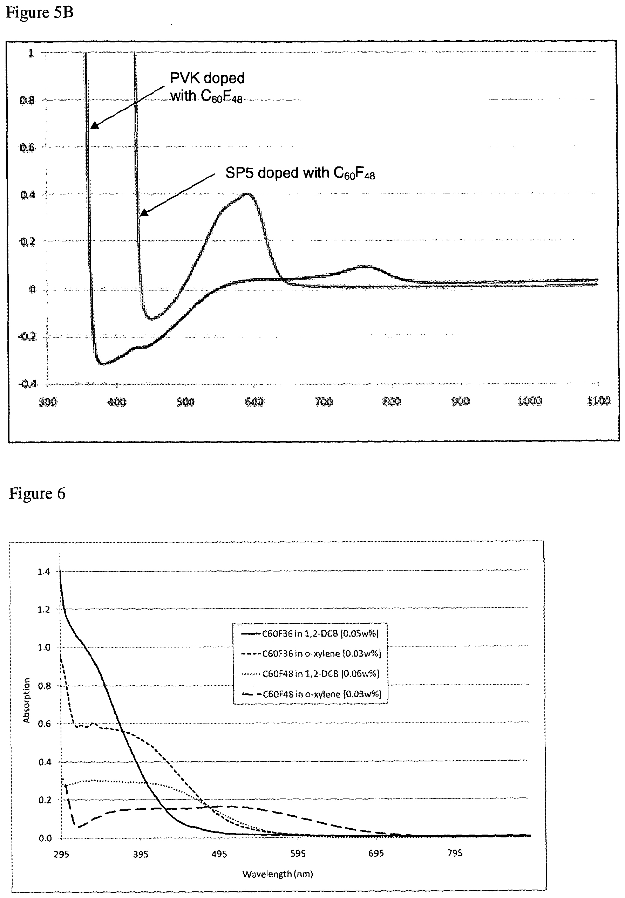

Figure 6 shows the UV-visible absorption spectrum for C₆₀F₃₆ and C₆₀F₄₈ in 1,2-dichlorobenzene and in o-xylene for concentrations in the range of 0.03 - 0.06 wt %.

Dilute solutions of C₆₀F₃₆ in both 1,2-DCB and in o-xylene are yellow. According to the UV-VIS spectrum, the absorption of C₆₀F₃₆ in o-xylene is red-shifted as compared to the absorption of C₆₀F₃₆ in 1,2-DCB.

Dilute solutions of C₆₀F₄₈ in 1,2-DCB are yellow, whereas solutions of C₆₀F₄₈ in o-xylene are light purple.

In the UV-Vis spectrum, the absorption of C₆₀F₄₈ in 1,2-DCB is similar to the absorption of C₆₀F₃₆ in o-xylene. Again, the solution of C₆₀F₄₈ in o-xylene is strongly red-shifted as compared to the solution of C₆₀F₄₈ in 1,2-DCB.

The UV-Vis spectra confirms that both 1,2-DCB and o-xylene are efficient solvents for both C₆₀F₃₆ and C₆₀F₄₈.

Without wishing to be bound by any theory, it is believed that the fullerene absorption appears to be a function of the relative acceptor strength of the part-fluorinated fullerene and of the donator strength of the aromatic solvent. C₆₀F₄₈ has a deeper LUMO (i.e. larger electron affinity) than C₆₀F₃₆, and o-xylene is expected to display a higher HOMO (i.e. smaller ionisation potential) than 1,2-DCB. Consequently, the combination of C₆₀F₃₆ / 1,2-DCB displays the deepest blue absorption, whereas the combination of C₆₀F₄₈ / o-xylene displays the largest red-shift.

Taking the red-shift of the fullerene absorption in o-xylene relative to 1,2-DCB as a measure of the interaction between fullerene and solvent molecules, the red-shifted fullerene absorptions in o-xylene suggest a strong interaction between o-xylene solvent molecules and the fluorinated C60 dopants. These interactions result in o-xylene being a good solvent for C₆₀F₃₆ and C₆₀F₄₈.

Figure 5B illustrates the UV-Vis absorption spectrum for a solution of polyvinylcarbazole (PVK) doped with C₆₀F₄₈ and for a solution of Semiconducting Polymer 5 doped with C₆₀F₄₈. Polyvinylcarbazole (PVK) has a HOMO level of -5.7 eV as measured by cyclic voltammetry, and Semiconducting Polymer 5 (SP5) has a HOMO level of -5.8 eV as measured by photoelectron spectroscopy. Semiconducting Polymer 5 contains only fluorene repeat units.

Both spectra were measured in 1,2-dichlorobenzene solution against a reference solution of pure dopant C60F48 in 1,2-dichlorobenzene. The resulting difference spectra show doping-induced features at wavelengths above 500nm, illustrating doping of these polymers.

### Device Examples

### General Device Process

A substrate carrying ITO was cleaned using UV / Ozone. A crosslinkable hole-injection layer was formed by depositing a semiconducting polymer doped with C₆₀F₃₆ by spin-coating from a 1 wt % 1,2-dichlorobenzene solution (unless stated otherwise) followed by thermal crosslinking. A hole-transporting layer, if present, was formed by spin-coating an undoped, crosslinkable hole transporting polymer, which may be the same as or different to the semiconducting polymer, from an o-xylene solution followed by thermal crosslinking. A light-emitting layer was formed by depositing a light-emitting formulation by spin-coating from o-xylene solution. Where present, an organic electron transporting layer was formed by co-evaporation of the electron transporting material Bathocuproine (BCP available from Sigma-Aldrich with 20 vol.% of elemental barium to a thickness of 30 nm. A cathode was formed by evaporation of a first layer of a metal fluoride to a thickness of about 3 nm, a second layer of aluminium to a thickness of about 100 nm and an optional third layer of silver.

### Comparative Devices

For the purpose of comparison, devices were prepared as described above except that either no dopant was used for the hole injection layer; non-fluorinated fullerene C₆₀ was used as the dopant; or the hole injection layer was formed by spin-coating an aqueous formulation of a hole-injection material available from Plextronics, Inc.

### Blue devices

Exemplary and comparative blue OLEDs were formed according to the general device process above wherein the hole-injection layer (HIL) was formed to a thickness of 55 nm by spin-coating formulations comprising either SP1 or SP2 as illustrated below, and a light-emitting layer was formed by spin-coating Blue Polymer illustrated below to a thickness of 60 nm:

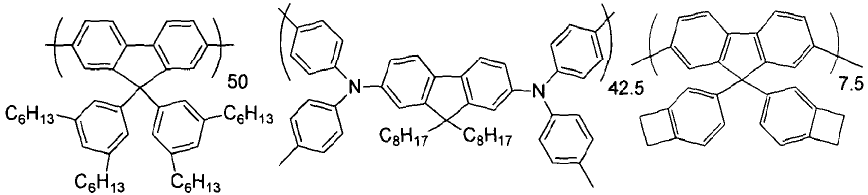

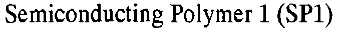

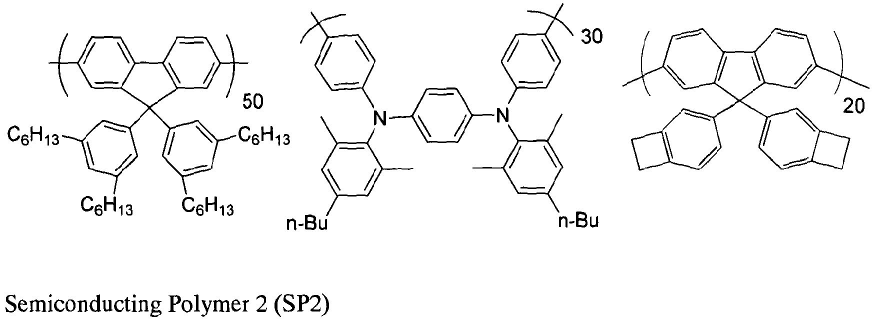

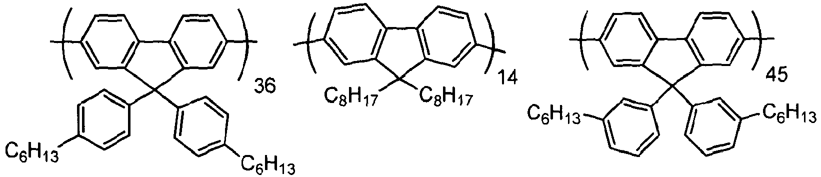

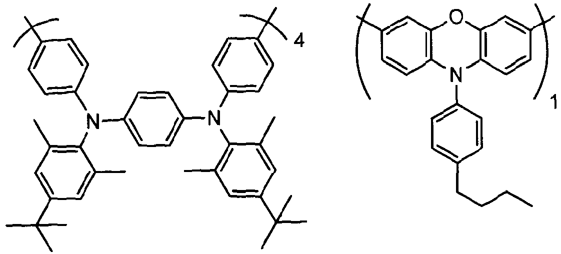

### Blue Polymer

The polymers illustrated above were prepared by Suzuki polymerisation as described in WO 00/53656.

Neither the optional undoped hole-transporting layer nor the optional electron-transporting layer was formed.

Results are set out below. In all results hereinafter, and unless stated otherwise, luminance was measured at 6V, and lifetime is the time taken for luminance to fall by 50% at constant current from an initial luminance of 5,000 cd/m².

| | Device Example 1 | Device Example 2 | Comparative Device 1 | Comparative Device 2 | Comparative Device 3 |
|---|---|---|---|---|---|
| HIL material | SP 1 | SP2 | SP1 | SP1 | SP2 |
| HIL dopant | C₆₀F₃₆ | C₆₀F₃₆ | None | C₆₀ | None |
| HIL doping level (wt %) | 3 | 3 | - | 3 | - |
| Luminance (cd/m²) | 3440 | 1370 | 36 | 11 | 150 |
| Lifetime (hours) | 49 | 22 | <0.5 | 0.8 | <0.5 |

It can be seen that both lifetime and luminance of the exemplary devices are much higher than comparative devices.

The results illustrate that providing a doped interface at the surface of the anode may significantly improve efficiency and / or lifetime of an OLED. Without wishing to be bound by any theory, an undoped interface may allow strong localized fields to form between the anode and the cathode at points where the anode and cathode are closest together (e.g. due to surface roughness of the anode), resulting in current leakage.

Moreover, the results demonstrate that the choice of dopant may be important and that partially fluorinated fullerenes are particularly advantageous as dopant for a doped hole injection layer.

### Green devices

Exemplary and comparative green OLEDs were formed according to the general device process above wherein the hole-injection layer (HIL) was formed to a thickness of 55 nm by spin-coating formulations comprising either SP1 or SP2, and a light-emitting layer was formed by spin-coating a composition of Green Host and 20 wt% of Green Emitter illustrated below to a thickness of 80 nm:

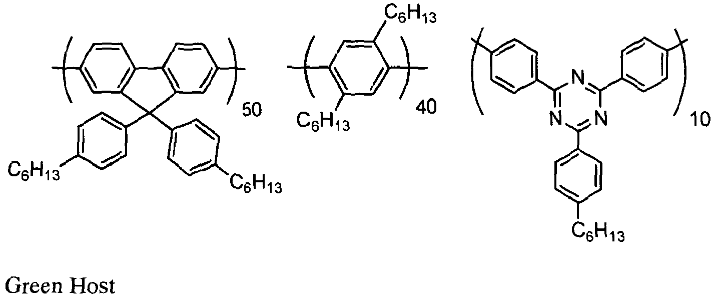

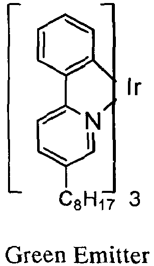

The polymer illustrated above was prepared by Suzuki polymerisation as described in WO 00/53656.

Neither the optional undoped hole-transporting layer nor the optional electron-transporting layer was formed.

| | Device Example 4 | Device Example 5 | Comparative Device 4 | Comparative Device 5 | Comparative Device 6 |
|---|---|---|---|---|---|
| HIL material | SP 1 | SP2 | SP1 | SP1 | SP2 |
| HIL dopant | C₆₀F₃₆ | C₆₀F₃₆ | None | C₆₀ | None |
| HIL doping level (wt %) | 3 | 3 | - | 3 | - |
| Luminance (cd/m²) | 256 | 115 | 5 | 8 | 55 |
| Lifetime (hours) | 5.3 | 3.2 | 2.7 | 2.0 | 1.8 |

### Red devices

Exemplary and comparative red OLEDs were formed according to the general device process above wherein the hole-injection layer (HIL) was formed to a thickness of 55 nm by spin-coating formulations comprising either SP1 or SP2, and a light-emitting layer was formed by spin-coating a composition of Red Host and 7.5 wt% of Red Emitter illustrated below to a thickness of 80 nm:

The polymers illustrated above were prepared by Suzuki polymerisation as described in WO 00/53656.

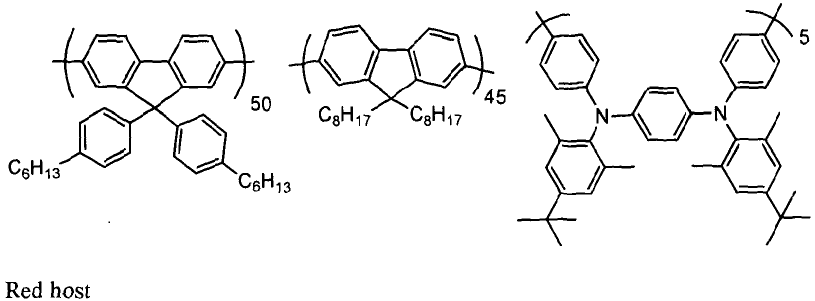

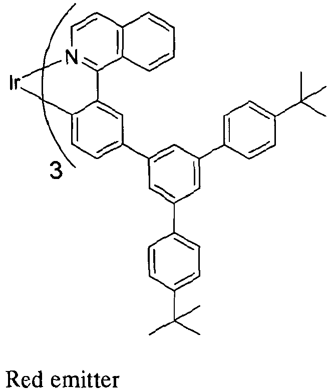

The polymer illustrated above was prepared by Suzuki polymerisation as described in WO 00/53656.

Neither the optional undoped hole-transporting layer nor the optional electron-transporting layer was formed.

| | Device Example 7 | Device Example 8 | Comparative Device 7 | Comparative Device 8 | Comparative Device 9 |
|---|---|---|---|---|---|
| HIL material | SP 1 | SP2 | SP1 | SP1 | SP2 |
| HIL dopant | C₆₀F₃₆ | C₆₀F₃₆ | None | C₆₀ | None |
| HIL doping level (wt %) | 3 | 3 | - | 3 | - |
| Luminance (cd/m²) | 296 | 230 | 20 | <1 | 95 |
| Lifetime (hours) | 99 | 71 | 7 | 43 | 8 |

### Effect of doping concentration

Devices were prepared as described above in which the doping concentration was varied.

Blue Device Examples 10-13 were prepared as per Device Example 1 except that the hole injection layer was formed to a thickness of 35 nm. Effect of variation of the doping concentration is illustrated in the table below.

| Device Example | Doping level (wt%) | Luminance (cd/m2) | Lifetime (hours) |
|---|---|---|---|
| 10 | 1 | 6435 | 40.1 |
| 11 | 3 | 3735 | 42.3 |
| 12 | 5 | 2530 | 31.0 |
| 13 | 10 | 1370 | 15.8 |

Green Device Examples 14-17 were prepared as per Device Example 4 except that the hole injection layer was formed to a thickness of 35 nm. Effect of variation of the doping concentration is illustrated in the table below.

| Device Example | Doping level (wt%) | Luminance (cd/m2) | Lifetime (hours) |
|---|---|---|---|
| 14 | 1 | 167 | 3.3 |
| 15 | 3 | 152 | 1.9 |
| 16 | 5 | 100 | 1.2 |
| 17 | 10 | 63 | <0.5 |

Devices with electron transporting layers and / or undoped hole transporting layers

### Device Example 18

A blue OLED was prepared as per Device Example 1 except that the hole injection layer was formed to a thickness of 30 nm with a doping level of 1 wt % and an electron transporting layer was formed as described in the general device process.

### Comparative Device 18

A device was prepared as per Device Example 18 except that the hole injection layer was not doped.

### Device Example 19

A blue OLED was prepared as per Device Example 18 except that the hole injection layer was formed to a thickness of 15 nm with a doping level of 5 wt %; and a hole transporting layer of thickness 15 nm was formed by spin-coating undoped Semiconducting Polymer 1 onto the hole injection layer.

| Device Example | HIL doping level (wt%) | Hole transport layer? | Electron transport layer? | Luminance at 8 V (cd/m²) | Lifetime (hours) |
|---|---|---|---|---|---|
| 18 | 1 | No | Yes | 1890 | 14.6 |
| Comparative Device 18 | 0 | No | Yes | 7 | <0.5 |
| 19 | 5 | Yes | Yes | 2075 | 14.9 |

### Device Example 20

A green OLED was prepared as per Device Example 4 except that the hole injection layer was formed to a thickness of 30 nm with a doping level of 1 wt % and an electron transporting layer was formed as described in the general device process.

### Comparative Device 20

A device was prepared as per Device Example 20 except that the hole injection layer was not doped.

### Device Example 21

A green OLED was prepared as per Device Example 20 except that the hole injection layer was formed to a thickness of 15 nm with a doping level of 5 wt %; and a hole transporting layer of thickness 15 nm was formed by spin-coating undoped Semiconducting Polymer 1 onto the hole injection layer.

| Device Example | HIL doping level (wt%) | Hole transport layer? | Electron transport layer? | Luminance at 8 V (cd/m²) | Lifetime (hours) |
|---|---|---|---|---|---|
| 20 | 1 | No | Yes | 380 | 3.1 |
| Comparative Device 20 | 0 | No | Yes | 62 | 1.3 |
| 21 | 5 | Yes | Yes | 206 | 2.4 |

### Device Example 22

A red OLED was prepared as per Device Example 4 except that the hole injection layer was formed to a thickness of 30 nm with a doping level of 1 wt % and an electron transporting layer was formed as described in the general device process.

### Comparative Device 22

A device was prepared as per Device Example 20 except that the hole injection layer was not doped.

### Device Example 23

A red OLED was prepared as per Device Example 22 except that the hole injection layer was formed to a thickness of 15 nm with a doping level of 5 wt %; and a hole transporting layer of thickness 15 nm was formed by spin-coating undoped Semiconducting Polymer 1 onto the hole injection layer.

| Device Example | HIL doping level (wt%) | Hole transport layer? | Electron transport layer? | Luminance at 8 V ( cd/m²) | Lifetime (hours) |
|---|---|---|---|---|---|
| 22 | 1 | No | Yes | 134 | 53.5 |
| Comparative Device 22 | 0 | No | Yes | 3 | <0.5 |
| 23 | 5 | Yes | Yes | 135 | 47.5 |

### Device Example 24

A blue OLED was prepared according to the general device process in which the hole-injection layer was formed by spin-coating Semiconducting Polymer 4 doped with 5 wt % of C₆₀F₃₆; the undoped hole-transporting layer was formed by spin-coating a 0.6 wt % solution of undoped Semiconducting Polymer 4; and the light-emitting layer was formed by spin-coating Blue Polymer 2 formed by Suzuki polymerization as described in WO 00/53656 of monomers in the relative molar amounts given below with 93.75 mol % of fluorene repeat units:

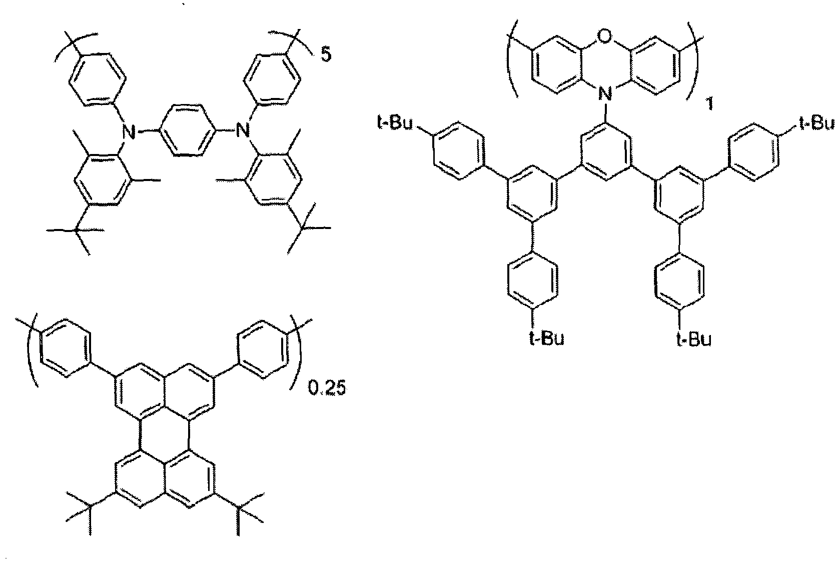

### Blue Polymer 2

### Device Example 25

A device was formed as described in Device Example 24 except that Semiconducting Polymer 4 used to form the hole injection layer was doped with 10 wt % of C₆₀F₃₆

### Comparative Device 24

A device was formed as described in Device Example 24 except that the hole injection layer comprising C₆₀F₃₆ was replaced with a hole-injection material available from Plextronics Inc.

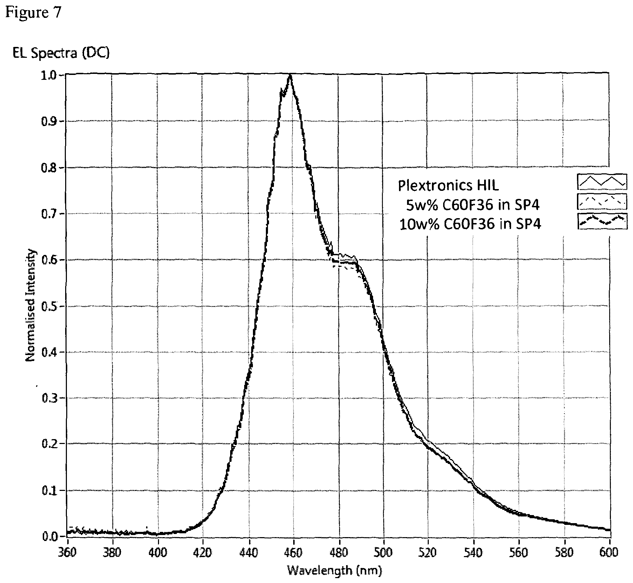

With reference to Figure 7, it can be seen that the electroluminescence spectra are very similar, with a slightly deeper blue CIE-y coordinate in case of the C₆₀F₃₆-doped HILs as compared to the Plextronics HIL.

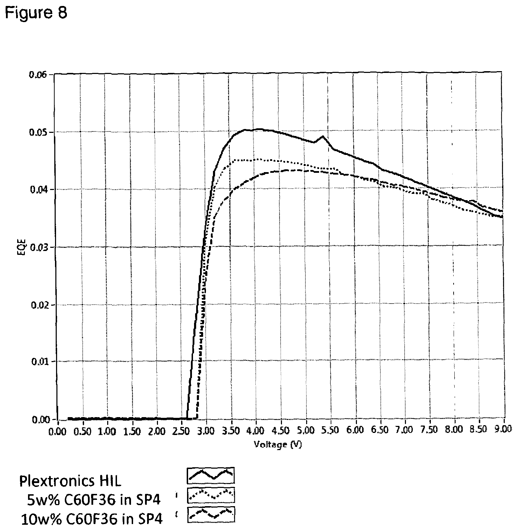

With reference to Figure 8, efficiency at 5 % doping (Device Example 24) is similar to or better than efficiency of Comparative Device 24 using a Plextronics HIL.

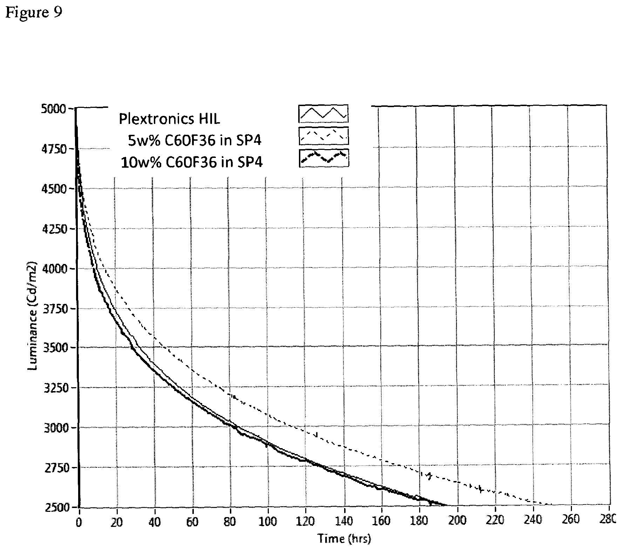

With reference to Figure 9, lifetimes of Device Examples 24 and 25 are similar to or better than that of Comparative Device 24.

### Transparent cathode device

### Device Example 26

A device was prepared as described in Device Example 1 except that a 100 nm thick layer of the silver-palladium-copper alloy (APC) was used to form the anode; the hole injection layer was formed to a thickness of 15 nm with a doping level of 5 wt %; a hole transporting layer of thickness 15 nm was formed by spin-coating undoped Semiconducting Polymer 1 onto the hole injection layer; and a transparent cathode was formed from a first layer of a metal fluoride (3nm), a second layer of aluminium (5 nm) and a third layer of silver (20 nm).

The luminance of the device at 8V was 3220 cd / m²

### Light-Emitting Apparatus

Hereinafter, a light-emitting apparatus using the organic light-emitting device of an embodiment of the present invention, and a method of producing the light-emitting apparatus will be described. The light-emitting apparatus is used, for example, as an illuminating device and a display device. In the present embodiment, as an example thereof, a bottom emission type active matrix-driven display device will be described.

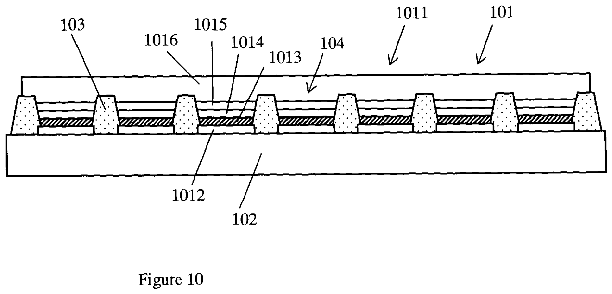

Figure 10 is a sectional view schematically showing a light-emitting apparatus 101 of the present embodiment. The light-emitting apparatus 101 is carried on substrate 102, and includes a plurality of organic light-emitting pixels or subpixels 1011 formed on the carrying substrate 102, and a bank 103 (The patterned layer described above) separating the plurality of pixels or subpixels 1011 from one another. An opening 104 of the bank 103 is formed at a pixel position in a plan view. The opening 104 of the bank 103 is formed in, for example, an oval shape, a round or approximate round shape, a elliptical or approximate elliptical shape or a rectangle or approximate rectangle in a plan view.

Since the light-emitting apparatus 101 of the present embodiment is a bottom emission type active matrix-driven display device, the carrying substrate 102 is a surface through which light is extracted. Therefore, the carrying substrate 102 is selected in consideration of light-transmitting properties and thermal stability, and examples thereof include a glass substrate, a transparent plastic substrate and the like. In addition, a substrate, on which a drive circuit driving a plurality of organic light-emitting pixels or subpixels separately is formed in advance, may be employed. For example, a substrate, which has a thin-film transistor for driving each organic light-emitting pixel or subpixel, can be used as the carrying substrate. Further, an anode 1012 is separately disposed for every organic light-emitting pixel or subpixel 1011 on the carrying substrate 102. As the anode, an anode having a high light-transmitting property is preferable, and examples thereof include a thin film composed of indium tin oxide (ITO). In addition, for example, the anode 1012 is plate-like and is formed into an approximate rectangle in a plan view.

The bank 103 is principally formed in a region other than the anode 1012 in a plan view, and a part of the bank covers a periphery of the anode 1012. In other words, an opening 104 (defining a well described above) is formed in the bank 103 above the anode 1012. The surface of the anode 1012 is exposed through the opening 104. The bank 103 is composed of highly insulating organic or inorganic substance. Examples of suitable organic substances for the bank include resins such as an acrylic resin, a phenolic resin, and a polyimide resin. Examples of suitable inorganic substances for the bank include SiO2, SiN and the like. Examples of a method of forming the bank 103 include photolithography and the like.

The bank referred to herein is not only a substance merely for the purpose of holding the applied ink in place, but also a substance serving as an electrical insulator between the organic light-emitting pixels or subpixels and further serving as a pixel-defining layer to define a region from which light from the organic light-emitting device is output (that is, a pixel referred to in a display device).

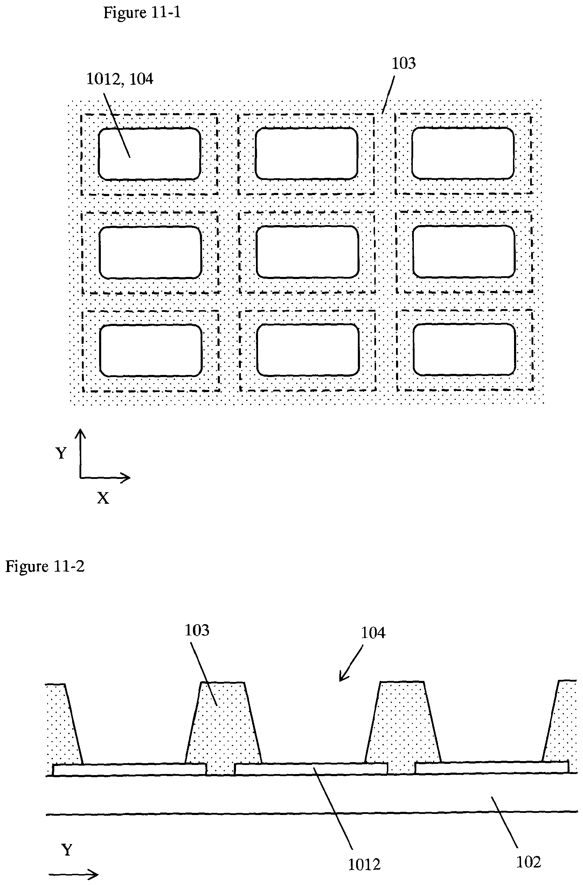

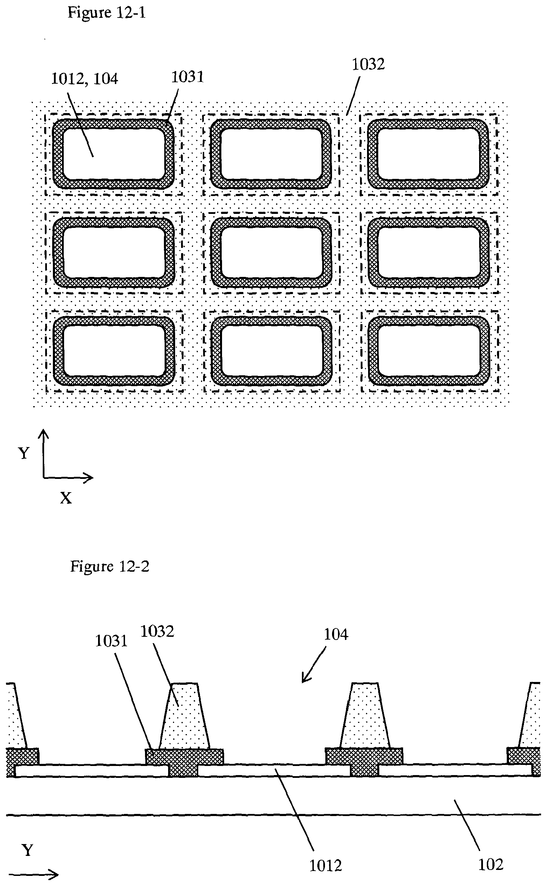

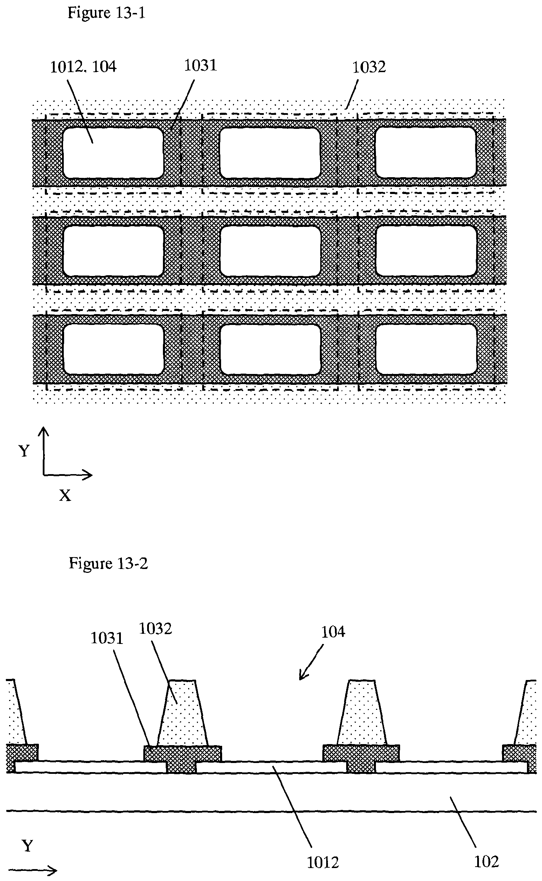

The configuration and the arrangement of the bank 103 may be appropriately set according to specifications of a display device such as number of pixels and resolution, ease of production, and a subsequent application process. As described above, the bank 103 may have a single bank structure characterized in that the number of layers of the bank is one (Figure 11-1 is a plan view of a single bank structure and Figure 11-2 is a sectional view of a single bank structure), or may have a dual bank structure characterized in that the bank 103 is composed of a first bank 1031 and a second bank 1032 and the number of layers of the bank is two (Figure 12-1 is a plan view of a dual bank structure and Figure 12-2 is a sectional view of a dual bank structure). When the bank has a dual structure, the bank 103 may have the above-mentioned channel structure (a bank structure in which in the light-emitting apparatus in which a plurality of organic light-emitting pixels or subpixels are linearly arranged to form a row and a plurality of the rows are arranged parallel to one another, the bank 103 is composed of a first bank 1031 and a second bank 1032, the first bank 1031 has openings at positions corresponding to the plurality of organic light-emitting pixels or subpixels, and the second bank 1032 is linearly disposed so as to divide the plurality of the rows on the first bank 1031) (Figure 13-1 is a plan view of a dual bank structure in which a second bank has a channel structure and Figure 13-2 is a sectional view of a dual bank structure in which a second bank has a channel structure). Further, the lyophilic/lyophobic properties of the bank 103 to an ink to be applied may be appropriately set according to shapes of the hole injection layer and light-emitting layer which are disposed within the opening 104 and stability of application/film-forming processes of the hole injection layer and light-emitting layer, and the lyophilic/lyophobic properties are not particularly limited.

The hole injection layer 1013 is disposed on a region where the surface of the anode 1012 is exposed by the opening 104.

When a hole injection layer with low specific resistance is formed, if the hole injection layer or the light-emitting layer is formed on the bank beyond the area of opening 104, light emission from an unintended region (in which a bank exists) out of the opening may be observed when a voltage is applied between electrodes to drive a device. This is caused if electric current flows laterally along the hole injection layer from a part of the hole injection layer overlying the anode to a part of the hole injection layer formed on the bank. When the hole injection layer extends across a plurality of pixels and, for example, the cathode is formed as a unit as described later, an adjacent pixel, to which a voltage is not applied, may also emit light (so-called cross talk). This is also caused since the current flows in the adjacent pixel through the hole injection layer. Both phenomena can be prevented by increasing the specific resistance of the hole injection layer, and the specific resistance is preferably 1x10⁵ Ohm cm or more. (reference literature: JP-A-2007-288074)

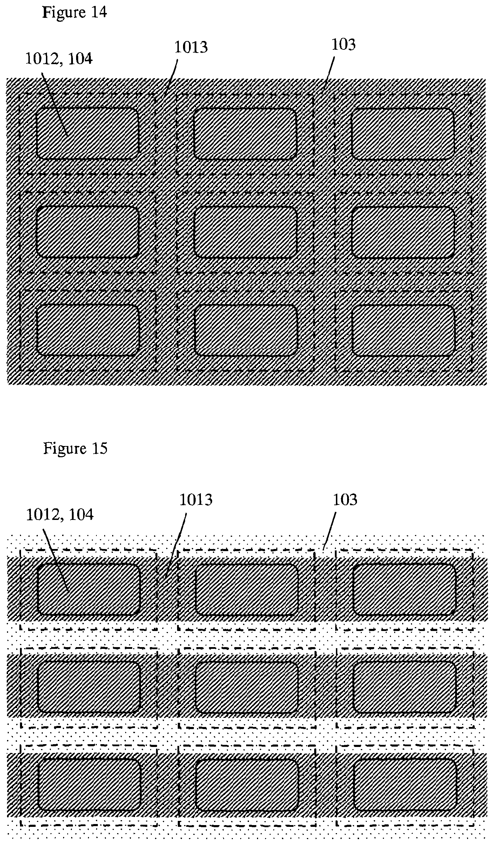

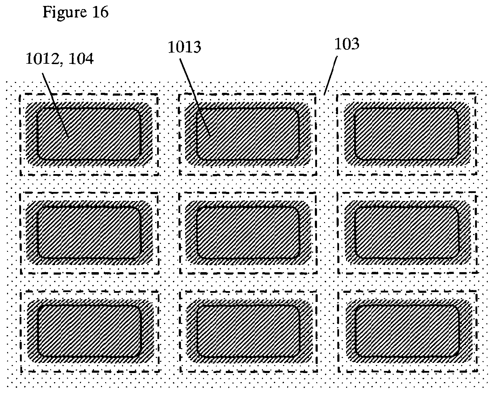

When the hole injection layer used in the organic light-emitting device of the present invention is applied, the hole injection layer does not necessarily have to be formed for every organic light-emitting pixel or subpixel, and a single, continuous hole injection layer may extend across a plurality of organic light-emitting pixels or subpixels if the specific resistance of the hole injection layer 1013 is 1x10⁵ Ohm cm or more, which may be so if the organic semiconductor and the dopant concentration are appropriately selected, as described above. Therefore, the hole injection layer 1013 may be disposed not only on a region where the surface of the anode 1012 is exposed, but also on the bank 103. More specific examples of the state in which the hole injection layer is disposed on the bank 103 may include a state in which as shown in Figure 14, the hole injection layer 1013 extends across a plurality of pixels 1011 in the form of a continuous hole injection layer. Further, as shown in Fig. 15, in the light-emitting apparatus 101 in which a plurality of organic light-emitting pixels or subpixels 1011 are linearly arranged to form a row and a plurality of the rows are arranged parallel to one another, the hole injection layer 1013 may be disposed across a plurality of organic light-emitting pixels or subpixels composing the row in the form of continuous hole injection layers linearly across pixels or subpixels in each row of the plurality of the rows. Further, as shown in Fig. 16, the hole injection layer 1013 may be disposed in the form of being divided for every organic light-emitting pixel or subpixel 1011. The hole injection layer 1013 for one or more pixels or subpixels may be disposed on the bank 103 but it is distinct for every pixel or subpixel 1011. The hole injection layer 1013 may rise along an inclined plane of the bank 103 but without being connected to an adjacent organic light-emitting pixel or subpixel (in Figs. 14, 15 and 16, for example, the arrangement of the hole injection layer 1013 in the single bank structure shown in Fig. 12 are illustrated, but it will be understood that, the bank structure is not limited to the single bank.)

When the hole injection layer used in the organic light-emitting device of the present invention is also formed on the bank 103, the hole injection layer 1013 does not necessarily have to be entirely covered with a light-emitting layer 1015 described later, and the hole injection layer 1013 may be in contact with a cathode 1016.

A process for forming the hole injection layer in the present invention can be a wet process or a dry process, but the wet process is preferably used. When the wet process is applied to a step of forming the hole injection layer, the hole injection layer may be formed by applying an ink formed from the above-mentioned doped organic semiconductor and a solvent at least onto an area within the opening, and evaporating the solvent.

Further, as described above, if the organic semiconductor and the dopant concentration are appropriately selected, the hole injection layer 1013 may be disposed not only on the region where the surface of the anode 1012 is exposed, but also on the bank 103. Therefore, in the step of forming the hole injection layer, the hole injection layer may be formed by applying the ink onto an anode within the opening and a bank and evaporating the solvent.

More specific examples of the state in which the ink is applied onto the bank may include a state in which in the step of forming the hole injection layer, the hole injection layer may be formed by applying the ink onto an anode within the opening and a whole area of the bank and evaporating the solvent. Further, in a method of producing the light-emitting apparatus in which a plurality of openings are linearly arranged to form a row and a plurality of the rows are arranged parallel to one another, in the step of forming the hole injection layer, the hole injection layer may be formed by applying the ink linearly along the row and evaporating the solvent.

Further, in the step of forming the hole injection layer, the hole injection layer may be formed by applying the ink for every opening and drying the ink. However, when the ink is applied onto an anode within the opening, involuntarily, the ink may reach an inclined plane of the bank (a side wall of the bank) or the ink may spill out of the opening, and therefore the ink may be applied onto the bank to form a hole injection layer.

When the hole injection layer is formed for every opening, or when the hole injection layer is formed linearly across a plurality of openings, techniques of coating separately, such as inkjet printing, nozzle printing, screen printing and roll printing, may be used, and when the hole injection layer is formed across all of plural openings as a unit, techniques of coating the entire surface, such as spin coating, dip coating and blade coating, may be used.

The hole transport layer 1014 may be formed between the hole injection layer 1013 and the light-emitting layer 1015, but it does not necessarily have to be formed. When the hole transport layer is formed, it may be formed discretely for every opening, or may be formed linearly across a plurality of openings if there is a plurality of openings aligned in a row, or may be formed across all of plural openings 104 as a unit. A process for forming a hole transport layer can be a wet process or a dry process, but the wet process is preferably used. When the hole transport layer is formed discretely for every opening, or when the hole transport layer is formed linearly across a plurality of openings, techniques of coating separately, such as inkjet printing, nozzle printing, screen printing and roll printing, may be used, and when the hole transport layer is formed throughout all of plural openings as a continuous layer extending across a plurality of pixels or subpixels, techniques of coating the entire surface, such as spin coating, dip coating and blade coating, may be used.

The light-emitting layer 1015 is formed on the hole injection layer 1013, and when the hole transport layer is formed, the light-emitting layer 1015 is formed on the hole transport layer 1014.

In the case of a full-color display device, at least three different kinds of organic light-emitting subpixels may be provided to form a pixel, each of which subpixels emits light of, for example, red color, green color or blue color. In the present embodiment, three kinds of organic light-emitting subpixels, each of which emits light of either red color, green color or blue color, may be prepared by employing .different kinds of light-emitting layers.

A process for forming a light-emitting layer can be a wet process or a dry process, but the wet process is preferably used. For the purpose of this, it is necessary, for example, to apply a material of the light-emitting layer separately, and techniques of coating separately, such as inkjet printing, nozzle printing, screen printing and roll printing, may be used. Further, in the case of a monocolor display device, techniques of coating the entire surface, such as spin coating, dip coating and blade coating, may be used since it is not necessary to apply a material of the light-emitting layer separately.

A cathode 1016 is disposed on the light-emitting layer 1015. In addition, in the present embodiment, the cathode 1016 is continuously formed to extend across a plurality of organic light-emitting pixels, and is disposed as an electrode common to a plurality of organic light-emitting pixels. That is, the cathode 1016 is formed not only on the light-emitting layer but also on the bank 103, and it is formed into one surface so that the cathode on the light-emitting layer 1015 and the cathode on the bank 103 are connected to each other. Examples of a process for forming the cathode include vacuum evaporation, sputtering, and laminating process in which a metallic thin film is thermocompression bonded.

By thus processing, the bottom emission type active matrix-driven display device can be prepared.

### Example of Light-Emitting Apparatus

An example of the present invention will be described. An organic light-emitting apparatus of the present invention corresponds to the organic light-emitting apparatus in Embodiment, and will be described with reference to Fig. 13-1 and Fig. 13-2. However, in this example, the anode is not separately disposed for every organic light-emitting pixel and disposed as a unit extending across a plurality of pixels in order to prepare the organic light-emitting apparatus easily, and a bank is formed so as to have a plurality of openings on the anode.

A glass substrate was used as a carrying substrate, and a layer of SiO2 was formed on the anode composed of ITO in a thickness of 120 nm as a first layer of the bank, and a plurality of openings (pixels) were formed in the first layer by photolithography. The opening has a rectangle in which one side in a Y-direction was 60 µm and the other side in an X-direction was 302 µm, and the opening was arranged with 330-micrometer pitches in the X-direction to form a row, and the rows were arranged parallel to one another with 100-micrometer pitches in the Y-direction. Next, a layer of polyimide resin was formed on the first layer of the bank in a thickness of 2.0 µm as a second layer of the bank by photolithography, and a bank with a width of 20 µm was linearly formed by photolithography so as to divide the rows of openings which were formed from the first layer of the bank and arranged parallel to one another with 100-micrometer pitches to form a dual bank having a channel structure.

As a hole injection layer, an organic solvent ink, in which C₆₀F₃₆ was mixed and dissolved in SP1 in an amount of 3% by weight with respect to the SP1, was linearly applied onto an area within the channel structure composed of a second layer of the bank for every row by nozzle printing to form a layer so as to have a layer thickness of 35 nm above the anode within the opening. In this case, the hole injection layer is formed to extend across a plurality of openings lined up in a Y-direction. Thereafter, the substrate was baked on a hot plate in a glove box filled with nitrogen to perform thermal crosslinking.

Next, as a hole transport layer, an organic solvent ink in which SP1 was dissolved was linearly applied onto an area within the channel structure for every row by nozzle printing to form a layer so as to have a layer thickness of 20 nm above the hole injection layer within the opening. Thereafter, the substrate was baked on a hot plate in a glove box filled with nitrogen to perform thermal crosslinking.

Next, as a light-emitting layer, an organic solvent ink in which a polymer of blue emission was dissolved was linearly applied onto an area within the channel structure for every row by nozzle printing to form a layer so as to have a layer thickness of 60 nm above the hole transport layer within the opening. Thereafter, the substrate was baked on a hot plate in a glove box filled with nitrogen. Subsequently, a cathode was formed on the light-emitting layer by vacuum evaporation coating, and each layer was sealed with glass to prepare an organic light-emitting apparatus. This was employed as Device Example 27.

In addition, for comparison, a hole injection layer was prepared by linearly applying an water-based ink of a hole injection material with low resistance onto an area within the channel structure composed of a second layer of the bank for every row by nozzle printing to form a layer so as to have a layer thickness of 35 nm above the anode within the opening, and the steps following the step of forming the hole transport layer were performed in the same manner as in Example 27 to obtain an organic light-emitting apparatus, and the organic light-emitting apparatus was employed as Comparative Example 27.

The luminance of an area (pixel) within the opening and the luminance of a region covered with SiO2 (bank region) between openings lined in a Y-direction at the time when passing an electric current of 0.05 mA through the light-emitting apparatuses were measured by use of Luminancephotometer (ProMetric1400, manufactured by Radiant Imaging, Inc.). The results of measurement are shown in following Table.

In addition, the specific resistance of the material used for the hole injection layer was determined by measuring, by four-terminal method, a sample (film thickness 60 nm) which was obtained by forming, by spin coating, a film of an ink containing a dissolved hole injection material on a substrate on which an electrode with a pattern in response to four-terminal method is deposited by vapor evaporation.

| | Hole injection layer | Specific resistance of layer [Ohm cm] | Luminance of area within opening [cd/m2] | Luminance on SiO2 bank [cd/m2] | Ratio of luminance of area within opening to luminance on SiO2 |
|---|---|---|---|---|---|
| Example 27 | SP1 doped C₆₀E₂₆ | 1.93x10⁷ | 103 | 0.105 | 0.104 |
| Comparative Example 27 | HIL with low resistance | 3.39x10³ | 58.0 | 15.3 | 26.3 |

As is evident from Table, when the hole injection layer with low specific resistance was formed to extend across a plurality of openings on the bank, light emission from an unintended region of a bank out of the opening was observed when a voltage was applied between electrodes to drive a device, and on the other hand, when SP1 doped with fluorinated fullerene was used as the hole injection layer, little light emission from the region of a bank was observed even when the hole injection layer was formed to extend across a plurality of openings on the bank.

## Claims

1. An organic light-emitting device comprising an anode formed from a metal, a metal alloy, a conductive metal oxide or mixtures thereof; a hole injection layer in physical contact with the anode; a light-emitting layer over the hole injection layer; and a cathode over the light-emitting layer, **characterized in that** the hole injection layer comprises an organic semiconductor material doped with a partially fluorinated fullerene.

2. An organic light-emitting device according to claim 1 wherein the anode is selected from the group consisting of indium tin oxide, indium zinc oxide, fluorine-doped tin oxide, tungsten trioxide, titanium dioxide, molybdenum trioxide, aluminium zinc oxide, gallium indium zinc oxide, aluminium, silver, palladium, copper, gold, platinum, and alloys thereof, for example silver-palladium-copper and molybdenum-chrome.

3. An organic light-emitting device according to claim 1 or 2 wherein the partially fluorinated fullerene is a partially fluorinated Buckminster fullerene.

4. An organic light-emitting device according to any preceding claim wherein the dopant is present in the range of about 0.1-20 wt %, optionally 0.1-5 wt %.

5. An organic light-emitting device according to any preceding claim wherein the organic semiconductor is a polymer.

6. An organic light-emitting device according to claim 5 wherein the organic semiconductor comprises repeat units of formula (I): 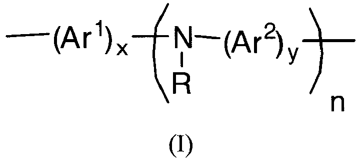 wherein Ar¹ and Ar² in each occurrence are independently selected from optionally substituted aryl or heteroaryl groups; n is greater than or equal to 1, preferably 1 or 2; R is H or a substituent; any of Ar¹, Ar² and R may be linked by a direct bond or linking group; and x and y are each independently 1, 2 or 3.

7. An organic light-emitting device according to claim 6 wherein R is a substituent.

8. An organic light-emitting device according to claim 6 or 7 wherein the organic semiconductor is a copolymer comprising less than 50 mol% of repeat units of formula (I).

9. An organic light-emitting device according to claim 5, 6, 7 or 8 wherein the polymer comprises an optionally substituted arylene repeat unit.

10. An organic light-emitting device according to claim 9 wherein the optionally substituted arylene repeat unit is an optionally substituted fluorene repeat unit or an optionally substituted phenylene repeat unit.

11. An organic light-emitting device according to any preceding claim wherein an undoped hole transporting layer, optionally a crosslinked layer, is disposed between the doped hole injection layer and the light-emitting layer.

12. An organic light-emitting device according to any preceding claim wherein the hole-injection layer is crosslinked.

13. An organic light-emitting device according to any preceding claim wherein the device comprises a light-emitting layer defining a plurality of pixel of the device, each pixel having a pixel area, and a bank having openings at positions corresponding to the plurality of pixels, wherein the hole-injection layer and light-emitting layer are disposed at least in the openings and in the pixel areas of the device.

14. An organic light-emitting device according to claim 13, wherein the hole injection layer is also disposed on the bank.

15. An organic light-emitting device according to claim 13 or 14, wherein the hole injection layer extends across a plurality of pixels of the device.

16. A method of forming an organic light-emitting device according to any one of claims 1 to 15 comprising the steps of:
providing a substrate carrying the anode;
depositing the doped organic semiconductor onto the anode to form the hole injection layer;
depositing a light-emitting material or light-emitting composition to form a light-emitting layer over the hole injection layer; and
forming a cathode over the light-emitting layer.

17. A method according to claim 16 wherein the hole transporting layer of claim 11 is formed by depositing an undoped hole transporting material or hole transporting composition over the hole injection layer.

18. A method according to claim 16 or 17 wherein the hole injection layer and the light-emitting layer are formed by inkjet printing.

19. A method according to any of claims 16 to 18 wherein the hole injection layer is crosslinked prior to deposition of the light-emitting layer or, if present, the hole-transporting layer.

20. A method according to any of claims 16 to 19 wherein the hole transporting layer is crosslinked prior to deposition of the light-emitting layer.

## Patentansprüche

1. Organische lichtemittierende Vorrichtung, umfassend eine Anode, die aus einem Metall, einer Metalllegierung, einem leitfähigen Metalloxid oder Gemischen davon besteht; eine Löcherinjektionsschicht in physischem Kontakt mit der Anode; eine lichtemittierende Schicht über der Löcherinjektionsschicht; und eine Kathode über der lichtemittierenden Schicht, **dadurch gekennzeichnet, dass** die Löcherinjekionsschicht ein organisches Halbleitermaterial, das mit teilfluoriertem Fulleren dotiert ist, umfasst.

2. Organische lichtemittierende Vorrichtung gemäß Anspruch 1, wobei die Anode ausgewählt ist aus der Gruppe bestehend aus Indiumzinnoxid, Indiumzinkoxid, fluordotiertem Zinnoxid, Wolframtrioxid, Titandioxid, Molybdäntrioxid, Aluminiumzinkoxid, Gallium-Indium-Zink-Oxid, Aluminium, Silber, Palladium, Kupfer, Gold, Platin und Legierungen davon, beispielsweise Silber-Palladium-Kupfer und Molybdän-Chrom.

3. Organische lichtemittierende Vorrichtung gemäß Anspruch 1 oder 2, wobei das teilfluorierte Fulleren ein teilfluoriertes Buckminsterfulleren ist.

4. Organische lichtemittierende Vorrichtung gemäß einem der vorstehenden Ansprüche, wobei der Dotierstoff in dem Bereich von etwa 0,1-20 Gew.-%, gegebenenfalls 0,1-5 Gew.-%, vorhanden ist.

5. Organische lichtemittierende Vorrichtung gemäß einem der vorstehenden Ansprüche, wobei der organische Halbleiter ein Polymer ist.

6. Organische lichtemittierende Vorrichtung gemäß Anspruch 5, wobei der organische Halbleiter Wiederholungseinheiten der Formel (I) umfasst: 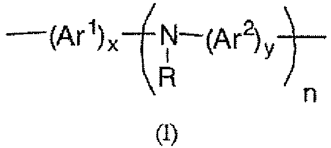 wobei Ar¹ und Ar² bei jedem Auftreten unabhängig ausgewählt sind aus gegebenenfalls substituierten Aryl- oder Heteroarylgruppen; n größer als oder gleich 1 ist, vorzugsweise 1 oder 2; R H oder ein Substituent ist; jedes von Ar¹, Ar² und R durch eine direkte Bindung oder eine Verknüpfungsgruppe verknüpft sein kann; und x und y jeweils unabhängig 1, 2 oder 3 sind.

7. Organische lichtemittierende Vorrichtung gemäß Anspruch 6, wobei R ein Substituent ist.

8. Organische lichtemittierende Vorrichtung gemäß Anspruch 6 oder 7, wobei der organische Halbleiter ein Copolymer ist, das weniger als 50 mol-% Wiederholungseinheiten der Formel (I) umfasst.

9. Organische lichtemittierende Vorrichtung gemäß Anspruch 5, 6, 7 oder 8, wobei das Polymer eine gegebenenfalls substituierte Arylen-Wiederholungseinheit umfasst.

10. Organische lichtemittierende Vorrichtung gemäß Anspruch 9, wobei die gegebenenfalls substituierte Arylen-Wiederholungseinheit eine gegebenenfalls substituierte Fluoren-Wiederholungseinheit oder eine gegebenenfalls substituierte Phenylen-Wiederholungseinheit ist.

11. Organische lichtemittierende Vorrichtung gemäß einem der vorstehenden Ansprüche, wobei eine undotierte löchertransportierende Schicht, gegebenenfalls eine vernetzte Schicht, zwischen der dotierten Löcherinjektionsschicht und der lichtemittierenden Schicht angeordnet ist.

12. Organische lichtemittierende Vorrichtung gemäß einem der vorstehenden Ansprüche, wobei die Löcherinjektionsschicht vernetzt ist.

13. Organische lichtemittierende Vorrichtung gemäß einem der vorstehenden Ansprüche, wobei die Vorrichtung eine lichtemittierende Schicht, die eine Vielzahl von Pixeln der Vorrichtung umfasst, wobei jedes Pixel eine Pixelfläche aufweist, und eine Bank mit Öffnungen an Positionen, die der Vielzahl von Pixeln entsprechen, umfasst, wobei die Löcherinjektionsschicht und die lichtemittierende Schicht wenigstens in den Öffnungen und in den Pixelflächen der Vorrichtung angeordnet sind.

14. Organische lichtemittierende Vorrichtung gemäß Anspruch 13, wobei die Löcherinjektionsschicht auch auf der Bank angeordnet ist.

15. Organische lichtemittierende Vorrichtung gemäß Anspruch 13 oder 14, wobei sich die Löcherinjektionsschicht über eine Vielzahl von Pixeln der Vorrichtung erstreckt.

16. Verfahren zum Herstellen einer organischen lichtemittierenden Vorrichtung gemäß einem der Ansprüche 1 bis 15, umfassend die Schritte:
Bereitstellen eines Substrats, das die Anode trägt;
Aufbringen des dotierten organischen Halbleiters auf die Anode, um die Löcherinjektionsschicht zu bilden;
Aufbringen eines lichtemittierenden Materials oder einer lichtemittierenden Zusammensetzung, um eine lichtemittierende Schicht über der Löcherinjektionsschicht zu bilden; und
Bilden einer Kathode über der lichtemittierenden Schicht.

17. Verfahren gemäß Anspruch 16, wobei die Löchertransportschicht gemäß Anspruch 11 durch Aufbringen eines/einer undotierten Löchertransportmaterials oder Löchertransportzusammensetzung über der Löcherinjektionsschicht gebildet wird.

18. Verfahren gemäß Anspruch 16 oder 17, wobei die Löcherinjektionsschicht und die lichtemittierende Schicht durch Tintenstrahldrucken gebildet werden.

19. Verfahren gemäß einem der Ansprüche 16 bis 18, wobei die Löcherinjektionsschicht vor dem Aufbringen der lichtemittierenden Schicht oder, falls vorhanden, der Löchertransportschicht vernetzt wird.

20. Verfahren gemäß einem der Ansprüche 16 bis 19, wobei die Löchertransportschicht vor dem Aufbringen der lichtemittierenden Schicht vernetzt wird.

## Revendications

1. Dispositif électroluminescent organique comprenant une anode formée à partir d'un métal, d'un alliage métallique, d'un oxyde métallique conducteur ou de mélanges de ceux-ci ; une couche d'injection de trous en contact physique avec l'anode ; une couche électroluminescente sur la couche d'injection de trous ; et une cathode sur la couche électroluminescente, **caractérisé en ce que** la couche d'injection de trous comprend un matériau semi-conducteur organique dopé avec un fullerène partiellement fluoré.

2. Dispositif électroluminescent organique selon la revendication 1 dans lequel l'anode est choisie dans le groupe constitué par l'oxyde d'étain et d'indium, l'oxyde d'indium et de zinc, l'oxyde d'étain dopé par du fluor, le trioxyde de tungstène, le dioxyde de titane, le trioxyde de molybdène, l'oxyde d'aluminium et de zinc, l'oxyde de gallium, d'indium et de zinc, l'aluminium, l'argent, le palladium, le cuivre, l'or, le platine et les alliages de ceux-ci, par exemple l'argent-palladium-cuivre et le molybdène-chrome.

3. Dispositif électroluminescent organique selon la revendication 1 ou 2 dans lequel le fullerène partiellement fluoré est un buckminsterfullerène partiellement fluoré.

4. Dispositif électroluminescent organique selon une quelconque revendication précédente dans lequel le dopant est présent dans la plage d'environ 0,1-20 % en poids, éventuellement de 0,1-5 % en poids.

5. Dispositif électroluminescent organique selon une quelconque revendication précédente dans lequel le semi-conducteur organique est un polymère.

6. Dispositif électroluminescent organique selon la revendication 5 dans lequel le semi-conducteur organique comprend des motifs répétés de formule (I) : 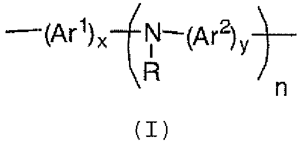 dans laquelle Ar¹ et Ar² à chaque occurrence sont indépendamment choisis parmi les groupes aryle ou hétéroaryle éventuellement substitués ; n est supérieur ou égal à 1, de préférence n vaut 1 ou 2 ; R est H ou un substituant ; l'un quelconque d'Ar¹, d'Ar² et de R peut être lié par une liaison directe ou un groupe de liaison ; et x et y valent chacun indépendamment 1, 2 ou 3.

7. Dispositif électroluminescent organique selon la revendication 6 dans lequel R est un substituant.

8. Dispositif électroluminescent organique selon la revendication 6 ou 7 dans lequel le semi-conducteur organique est un copolymère comprenant moins de 50 % en mole de motifs répétés de formule (I).

9. Dispositif électroluminescent organique selon la revendication 5, 6, 7 ou 8 dans lequel le polymère comprend un motif répété arylène éventuellement substitué.

10. Dispositif électroluminescent organique selon la revendication 9 dans lequel le motif répété arylène éventuellement substitué est un motif répété fluorène éventuellement substitué ou un motif répété phénylène éventuellement substitué.

11. Dispositif électroluminescent organique selon une quelconque revendication précédente dans lequel une couche de transport de trous non dopée, éventuellement une couche réticulée, est disposée entre la couche d'injection de trous dopée et la couche électroluminescente.

12. Dispositif électroluminescent organique selon une quelconque revendication précédente dans lequel la couche d'injection de trous est réticulée.

13. Dispositif électroluminescent organique selon une quelconque revendication précédente, le dispositif comprenant une couche électroluminescente délimitant une pluralité de pixels du dispositif, chaque pixel ayant une surface de pixel, et un bord ayant des ouvertures en des endroits correspondant à la pluralité de pixels, dans lequel la couche d'injection de trous et la couche électroluminescente sont disposées au moins dans les ouvertures et dans les surfaces de pixel du dispositif.

14. Dispositif électroluminescent organique selon la revendication 13, dans lequel la couche d'injection de trous est également disposée sur le bord.

15. Dispositif électroluminescent organique selon la revendication 13 ou 14, dans lequel la couche d'injection de trous s'étend sur une pluralité de pixels du dispositif.

16. Procédé de formation d'un dispositif électroluminescent organique selon l'une quelconque des revendications 1 à 15 comprenant les étapes consistant à :
fournir un substrat portant l'anode ;
déposer le semi-conducteur organique dopé sur l'anode pour former la couche d'injection de trous ;
déposer un matériau électroluminescent ou une composition électroluminescente pour former une couche électroluminescente sur la couche d'injection de trous ; et
former une cathode sur la couche électroluminescente.

17. Procédé selon la revendication 16 dans lequel la couche de transport de trous selon la revendication 11 est formée par dépôt d'un matériau de transport de trous non dopé ou d'une composition de transport de trous non dopée sur la couche d'injection de trous.

18. Procédé selon la revendication 16 ou 17 dans lequel la couche d'injection de trous et la couche électroluminescente sont formées par impression par jet d'encre.

19. Procédé selon l'une quelconque des revendications 16 à 18 dans lequel la couche d'injection de trous est réticulée avant le dépôt de la couche électroluminescente ou, si elle est présente, de la couche de transport de trous.

20. Procédé selon l'une quelconque des revendications 16 à 19 dans lequel la couche de transport de trous est réticulée avant le dépôt de la couche électroluminescente.
